# EUROPEAN PATENT SPECIFICATION

(11) **EP 2 856 524 B1**
(45) Date of publication and mention of the grant of the patent: **28.04.2021**
(21) Application number: 13796844.2
(22) Date of filing: 31.05.2013
(51) Int. Cl.: H01L 33/62, H01L 33/48

(54) **LIGHT EMITTER PACKAGES, SYSTEMS, AND METHODS**
LICHTEMITTERGEHÄUSE, SYSTEME UND VERFAHREN
BOÎTIERS D'ÉLÉMENTS ÉLECTROLUMINESCENTS, SYSTÈMES D'ÉLÉMENTS ÉLECTROLUMINESCENTS, ET PROCÉDÉS

(30) Priority: 31.05.2012 US 201261653809 P; 27.06.2012 US 201261665057 P; 10.07.2012 US 201261669738 P; 20.07.2012 US 201213554776
(43) Date of publication of application: 08.04.2015
(73) Proprietor: Cree, Inc., Durham, NC 27703 (US)
(72) Inventor: ABARE, Amber, C., Durham, NC 27703 (US); BRITT, Jeffrey, Carl, Cary, NC 27513 (US); CLARK, Joseph, G., Raleigh, NC 27608 (US); ROSADO, Raymond, Apex, NC 27502 (US); SUNDANI, Harsh, Raleigh, NC 27606 (US)
(74) Representative: Isarpatent
(86) International application number: PCT/US2013/043619
(87) International publication number: WO 2013/181538

(56) References cited:
- WO-A1-2012/002580
- WO-A1-2012/040085
- WO-A2-2009/067991
- JP-A- 2008 034 513
- US-A1- 2008 041 625
- US-A1- 2010 207 534
- US-A1- 2010 237 775
- US-A1- 2010 277 919
- US-A1- 2011 012 143
- US-A1- 2011 116 252
- US-A1- 2011 220 920

## Description

### CROSS REFERENCE TO RELATED APPLICATIONS

This application claims priority to U.S. Provisional Patent Application Serial Nos. 61/653,809 filed May 31, 2012, 61/665,057 filed June 27, 2012, and 61/669,738 filed July 10, 2012. This application further claims priority to U.S. Patent Application Serial No. 13/554,776 filed on July 20, 2012.

### TECHNICAL FIELD

The subject matter disclosed herein relates generally to light emitter packages, systems, and methods. More particularly, the subject matter disclosed herein relates to multi-chip light emitting diode (LED) packages, systems, and methods having improved performance at a lower cost.

### BACKGROUND

Light emitting diodes (LEDs) or LED chips are solid state devices that convert electrical energy into light. LED chips can be utilized in light emitter packages for providing different colors and patterns of light useful in various lighting and optoelectronic applications. For example, light emitter packages can be used in various LED light bulb and light fixture applications and are developing as replacements for incandescent, fluorescent, and metal halide high-intensity discharge (HID) lighting applications. US 2011/0220920 A1 refers to a method of forming a warm white light emitting device having high color rendering index values. The light-emitting device comprises an LED emitting light having a dominant wavelength in the blue color range, and a conformal recipient luminophoric medium. WO 2012/002580 A1 refers to a LED light source device, comprising a substrate, an electrode formed on the substrate and a white inorganic resist layer.

Manufacturers of LED lighting products are constantly seeking ways to reduce their cost in order to provide a lower initial cost to customers, and encourage the adoption of LED products. Brighter, more efficient LED chips and/or packages can allow lighting manufacturers to use fewer LED chips to get the same brightness at a lower cost or increase brightness levels using the same LED chip count and power.

Such improvements can enable delivery of improved light emitter packages and/or systems for less total cost than other solutions.

Thus, despite the availability of various light emitter packages in the marketplace, a need remains for brighter, more cost-effective light emitter packages, systems, and/or methods which consume the same and/or less power as compared to conventional packages and/or systems. Such packages, systems, and methods can also make it easier for end-users to justify switching to LED products from a return on investment or payback perspective.

### SUMMARY

The invention relates to a light emitter package and a method of providing a light emitter package as recited in the independent claims. Further advantageous embodiments are set out in the dependent claims. In accordance with this disclosure, light emitter packages, systems, and methods are provided and described herein. For example, packages, systems, and methods described herein can advantageously exhibit improved brightness, binning accuracy, light extraction, and/or ease of manufacture at a lower overall cost. In one aspect, packages, systems, and methods described herein offer cost-effective lighting solutions well suited for a variety of applications such as personal, industrial, and commercial lighting products and applications including, for example, indoor lighting, outdoor lighting, LED light bulbs, accent and track lighting, directional, low bay, high bay, roadway, parking, portable lighting, bicycle lighting, solar-powered lighting, battery-powered lighting, and high end lighting fixtures, products and/or applications. It is, therefore, an object of the present disclosure to provide light emitter packages, systems, and methods having improved performance, in one aspect, by utilizing metallic plating and/or optical conversion material disposed below portions of an optical element or lens, in addition to incorporating novel LED chips, novel chip-to-chip spacing, and/or novel placement of a reflective material, such as a solder mask within trenches of the package.

These and other objects of the present disclosure as can become apparent from the disclosure herein are achieved, at least in whole or in part, by the subject matter disclosed herein.

### BRIEF DESCRIPTION OF THE DRAWINGS

A full and enabling disclosure of the present subject matter including the best mode thereof to one of ordinary skill in the art is set forth more particularly in the remainder of the specification, including reference to the accompanying figures, in which:
Figure 1A and 1B are top plan and top perspective views, respectively, illustrating a light emitter package according to one aspect of the disclosure herein;
Figure 2 is a top perspective view illustrating a light emitter package according to another aspect of the disclosure herein;
Figure 3 is a bottom perspective view illustrating a light emitter package according to the disclosure herein;
Figure 4 is a cross-sectional view illustrating light emitter packages according to the disclosure herein;
Figure 5 illustrates a light emitter system or component incorporating one or more light emitter packages according to the disclosure herein;
Figure 6 illustrates a method of providing a light emitter package according to an aspect of the disclosure herein; and
Figures 7A to 9 are graphical illustrations of brightness and forward voltage data associated with light emitter packages and systems according to the disclosure herein.

### DETAILED DESCRIPTION

The subject matter disclosed herein is directed to packages, systems, and methods for use with light emitters, such as light emitting diodes (LEDs). Packages, systems, and methods described herein can exhibit improved performance, for example, improved efficiency, brightness, and/or light extraction at a lower cost than conventional package and/or systems. Packages and systems described herein can utilize a plurality of novel LED chips alone and/or in combination with other novel features such as placement or configuration of exposed metallic traces, chip-to-chip spacing, and/or reflective material, such as plastic or a solder mask material

In some aspects, packages, systems, and methods described herein provide a plurality of light emitters, such as LED chips, where a first LED chip directly attaches and electrically communicates to a cathode of the package and where a second LED chip wirebonds to an anode of the package.

In some aspects, string of serially connected LED chips can be disposed between the first and second LED chips passing electrical current from the cathode to the anode. This is novel and unexpected in view of conventional designs which include light emitters that are reverse biased and/or reversed in electrical polarity from LED chips disclosed herein. Wirebonds can be disposed along an outer perimeter of the plurality of LED chips to minimize any potential interference with light.

In some aspects, packages, systems, and methods described herein provide light emitters, or emitter chips, that are spaced at least apart at any distance between and/or any sub-ranges of any distance between approximately 0.010 mm and 1 mm. In some aspects, packages and systems disclosed herein can, for example and without limitation, comprise chip-to-chip spacing of between approximately 0.06 and 0.3 mm. In further aspects, packages and systems disclosed herein can comprise chip-to-chip spacing of at least approximately 0.03 mm or more, at least approximately 0.05 mm or more, at least approximately 0.06 mm or more (e.g., approximately 60 µm or more), at least approximately 0.10 mm or more, at least approximately 0.30 mm or more, at least approximately 0.50 mm or more, or more than approximately 0.625 mm. Such chip spacing can advantageously improve light extraction and/or brightness by minimizing an amount of light trapped between chips and/or blocked or absorbed by chips and/or components.

In some aspects, packages, systems, and methods disclosed herein provide exposed metal traces, where the exposed metal is not covered by any other material. The exposed metal traces can improve light reflection and can be disposed over portions of a submount disposed below the lens and outside of the lens base.

In some aspects, packages, systems, and methods disclosed herein provide trenches or gaps between one or more electrically conductive traces to which one or more light emitter chips can connect. Notably, a reflective material can be disposed within the trenches or gaps between emitter chips to improve light extraction per package. The reflective material can be white, silver, specularly reflective, diffusely reflective, a Lambertian coating, any reflective coating, plastic, or a solder mask material. The reflective material can be applied using any suitable technique, including for example, spraying, dispensing, dipping, gluing, brushing, etc.

Packages and systems described herein can exhibit improved light output, reliability, and efficacy by delivering, for example, up to and/or more than approximately 145 lumens per Watt (LPW) at 1 Watt (W) and approximately 25 °C; more than approximately 180 LPW at 1W and approximately 25 °C; or more than approximately 200 LPW at 1W and approximately 25 °C in selected color temperatures. Packages and systems described herein and the foregoing LPW values can be attained for emissions having at least one of a cool white (CW) color temperature, a neutral white color temperature, a warm white (WW) color temperature, and/or overlapping combinations thereof.

White emissions can have x, y color coordinates within eight or less MacAdam step ellipses of a reference point on the blackbody locus of a 1931 CIE Chromaticity Diagram. In some aspects, white emissions can have x, y color coordinates within four, or between approximately four and eight MacAdam step ellipses of a reference point on the blackbody locus of a 1931 CIE Chromaticity Diagram. In certain aspects, such a reference point on the blackbody locus may have a color temperature of less than or equal to 7000 K, less than or equal to 4000 K, less than or equal to 3500 K, or less than or equal to 3000 K. In certain aspects, combined emissions from a lighting apparatus as described herein embody at least one of (a) a color rendering index (CRI) value of at least 70 CRI, at least 75 CRI, at least 80 CRI, or at least a minimum of 85 CRI. In some aspects, the forgoing LPW values can be attached for selected color temperatures including cool white (CW) color temperatures of around 6000 K or warm white (WW) color temperatures of around 3000 K or CW colors around 5500 K. In some aspects, light emitter packages, systems, and/or methods described herein can deliver up to approximately 2050 lumens (Im) at 15W and 25 °C in CW temperatures of around 6000 K.

Notably, light emitter packages, systems, and/or methods described herein can provide small optical lighting sources with high lumen density and excellent color consistency. In some aspects, the high lumen output and excellent chip-to-chip color consistency can be provided in a small form factor and/or small footprint with about a 7 mm x 7 mm package size and a 6 mm optical source. Notably, a small footprint can provide a narrow beam for superior, improved optical control making it ideal for high lumen, directional lighting applications.

Reference will be made in detail to possible aspects or embodiments of the subject matter herein, one or more examples of which are shown in the figures. Each example is provided to explain the subject matter and not as a limitation. In fact, features illustrated or described as part of one embodiment can be used in another embodiment to yield still a further embodiment. It is intended that the subject matter disclosed and envisioned herein covers such modifications and variations.

As illustrated in the various figures, some sizes of structures or portions are exaggerated relative to other structures or portions for illustrative purposes and, thus, are provided to illustrate the general structures of the present subject matter. Furthermore, various aspects of the present subject matter are described with reference to a structure or a portion being formed on other structures, portions, or both. As will be appreciated by those of skill in the art, references to a structure being formed "on" or "above" another structure or portion contemplates that additional structure, portion, or both may intervene. References to a structure or a portion being formed "on" another structure or portion without an intervening structure or portion are described herein as being formed "directly on" the structure or portion. Similarly, it will be understood that when an element is referred to as being "connected", "attached", or "coupled" to another element, it can be directly connected, attached, or coupled to the other element, or intervening elements may be present. In contrast, when an element is referred to as being "directly connected", "directly attached", or "directly coupled" to another element, no intervening elements are present.

Furthermore, relative terms such as "on", "above", "upper", "top", "lower", or "bottom" are used herein to describe one structure's or portion's relationship to another structure or portion as illustrated in the figures. It will be understood that relative terms such as "on", "above", "upper", "top", "lower" or "bottom" are intended to encompass different orientations of the package or component in addition to the orientation depicted in the figures. For example, if the package or component in the figures is turned over, structure or portion described as "above" other structures or portions would now be oriented "below" the other structures or portions. Likewise, if the package or component in the figures are rotated along an axis, structure or portion described as "above", other structures or portions would be oriented "next to" or "left of" the other structures or portions. Like numbers refer to like elements throughout.

Unless the absence of one or more elements is specifically recited, the terms "comprising", including", and "having" as used herein should be interpreted as openended terms that do not preclude the presence of one or more elements.

As used herein a "ceramic based material" or the term "ceramic based" includes a material that consists primarily of a ceramic material, such as an inorganic, non-metallic material made from compounds of a metal or metalloid and a non-metal (e.g., aluminum nitride, aluminum oxide, beryllium oxide, silicon carbide). A "non-ceramic based material" consists primarily a metallic material, a primarily organic (e.g., polymeric) material, and/or a primarily synthetic or semi-synthetic organic solid that can be dispensed or molded (e.g., plastic).

As used herein, the terms "specular" reflection and/or being "specularly" reflective describes a mirror-like reflection of light from a surface, in which light from a single incoming direction is reflected into a single outgoing direction.

As used herein, the terms "diffuse" reflection and/or being "diffusively" reflective describes reflection of light from a surface such that an incident ray is reflected at a plurality of angles rather than at just one angle as in the case of specular reflection.

Light emitter packages according to embodiments described herein can comprise group III-V nitride (e.g., gallium nitride (GaN)) based LED chips or lasers. Fabrication of LED chips and lasers is generally known and only briefly described herein. LED chips or lasers can be fabricated on a growth substrate, for example, a silicon carbide (SiC) substrate, such as those devices manufactured and sold by Cree, Inc. of Durham, North Carolina. Other growth substrates are also contemplated herein, for example and not limited to sapphire, silicon (Si), and GaN. In one aspect, SiC substrates/layers can be 4H polytype silicon carbide substrates/layers. Other SiC candidate polytypes, such as 3C, 6H, and 15R polytypes, however, can be used. Appropriate SiC substrates are available from Cree, Inc., of Durham, N.C., the assignee of the present subject matter, and the methods for producing such substrates are set forth in the scientific literature as well as in a number of commonly assigned U.S. patents, including but not limited to U.S. Patent No. Re. 34,861; U.S. Patent No. 4,946,547; and U.S. Patent No. 5,200,022. Any other suitable growth substrates are contemplated herein.

As used herein, the term "Group III nitride" refers to those semiconducting compounds formed between nitrogen and one or more elements in Group III of the periodic table, usually aluminum (Al), gallium (Ga), and indium (In). The term also refers to binary, ternary, and quaternary compounds such as GaN, AIGaN and AlInGaN. The Group III elements can combine with nitrogen to form binary (e.g., GaN), ternary (e.g., AIGaN), and quaternary (e.g., AlInGaN) compounds. These compounds may have empirical formulas in which one mole of nitrogen is combined with a total of one mole of the Group III elements. Accordingly, formulas such as AlxGa1-xN where 1>x>0 are often used to describe these compounds. Techniques for epitaxial growth of Group III nitrides have become reasonably well developed and reported in the appropriate scientific literature.

Although various embodiments of LED chips disclosed herein can comprise a growth substrate, it will be understood by those skilled in the art that the crystalline epitaxial growth substrate on which the epitaxial layers comprising an LED chip are grown can be removed, and the freestanding epitaxial layers can be mounted on a substitute carrier substrate or substrate which can have different thermal, electrical, structural and/or optical characteristics than the original substrate. The subject matter described herein is not limited to structures having crystalline epitaxial growth substrates and can be used in connection with structures in which the epitaxial layers have been removed from their original growth substrates and bonded to substitute carrier substrates.

Group III nitride based LED chips according to some embodiments of the present subject matter, for example, can be fabricated on growth substrates (e.g., Si, SiC, or sapphire substrates) to provide horizontal devices (with at least two electrical contacts on a same side of the LED chip) or vertical devices (with electrical contacts on opposing sides of the LED chip). Moreover, the growth substrate can be maintained on the LED chip after fabrication or removed (e.g., by etching, grinding, polishing, etc.). The growth substrate can be removed, for example, to reduce a thickness of the resulting LED chip and/or to reduce a forward voltage through a vertical LED chip. A horizontal device (with or without the growth substrate), for example, can be flip chip bonded (e.g., using solder) to a carrier substrate or printed circuit board (PCB), or wirebonded. A vertical device (with or without the growth substrate) can have a first terminal (e.g., anode or cathode) solder bonded to a carrier substrate, mounting pad, or PCB and a second terminal (e.g., the opposing anode or cathode) wirebonded to the carrier substrate, electrical element, or PCB. Examples of vertical and horizontal LED chip structures are discussed by way of example in U.S. Publication No. 2008/0258130 to Bergmann et al. and in U.S. Patent No. 7,791,061 to Edmond et al. which issued on September 7, 2010.

One or more LED chips can be at least partially coated with one or more phosphors. Notably, the LED chips can be coated with one or more phosphors prior to die attachment within the LED package. This can improve ease of manufacture and/or cost as other portions of the package aside from the LED chips do not need to have phosphor applied, and as the phosphor can be inexpensively applied, for example, by spraying the layer on prior to die attaching LED chips within package. The layer can be optionally roughened by grinding or other mechanical or chemical roughening process to improve light extraction and reflection.

In some aspects, the phosphors can absorb a portion of light from the LED chip and emit a different wavelength of light such that the light emitter package emits a combination of light from each of the LED chip and the phosphor. In one embodiment, the light emitter package emits what is perceived as white light resulting from a combination of light emission from the LED chip and the phosphor. In one embodiment according to the present subject matter, a white emitting package can consist of an LED chip that emits light in the blue wavelength spectrum and a phosphor that absorbs some of the blue light and re-emits light in the yellow wavelength spectrum. The package can therefore emit a white light combination of blue and yellow light. In other embodiments, the LED chips emit a non-white light combination of blue and yellow light as described in U.S. Patent No. 7,213,940. LED chips emitting red light or LED chips covered by a phosphor that absorbs LED light and emits a red light are also contemplated herein.

LED chips can be coated with a phosphor using many different methods, with one suitable method being described in U.S. Patent Application Serial Nos. 11/656,759 and 11/899,790, both entitled "Wafer Level Phosphor Coating Method and Devices Fabricated Utilizing Method". Other suitable methods for coating one or more LED chips are described in U.S. Patent No. 8,058,088 entitled "Phosphor Coating Systems and Methods for Light Emitting Structures and Packaged Light Emitting Diodes Including Phosphor Coating" which issued on November 15, 2011, and the continuation-in-part application U.S. Patent Application Serial No. 12/717,048 entitled "Systems and Methods for Application of Optical Materials to Optical Elements".

LED chips can also be coated using other methods such as electrophoretic deposition (EPD), with a suitable EPD method described in U.S. patent Application Serial No. 11/473,089 entitled "Close Loop Electrophoretic Deposition of Semiconductor Devices". It is understood that light emitter packages and methods according to the present subject matter can also have multiple LED chips of different colors, one or more of which can be white emitting.

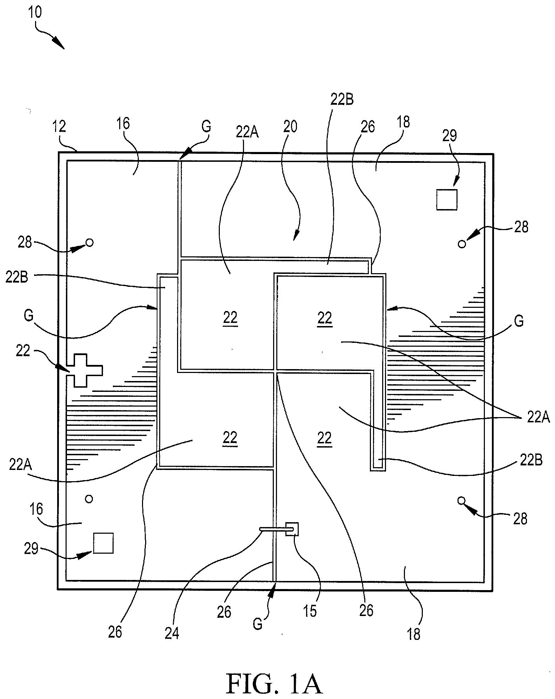

Figures 1A to 9 are embodiments of packages, systems, and methods for use with multiple light emitters, such as multiple LED chips. Light emitter packages and systems described herein can advantageously be configured for improved performance, such as improved brightness, by delivering more LPW at an improved, lower cost than conventional packages and systems. In general, light emitter packages and/or systems described herein can be sorted or binned both at "hot" temperatures (approximately 85 °C) or "cold" temperatures (e.g., approximately 25 °C). Packages and/or systems can be sorted or binned into groups or ranges based upon color temperature, wavelength, and/or brightness. In some aspects, a two-step binning process can be used to match the color consistency delivered by incandescent light bulbs.

Improved performance and/or novel aspects of improved light emitter packages, systems, and methods are discussed hereinbelow. Notably, novel light emitter packages disclosed herein can deliver approximately 145 LPW or more at 1W and 25 °C; approximately 180 LPW or more at 1W and 25 °C; and/or approximately 200 LPW or more at 1W and 25 °C at an improved, low cost using, for example, a plurality of novel LED chips, exposed metal traces, reflective solder mask material disposed in gaps or trenches between traces, and a larger lens. In some aspects, emitter packages consisting of a plurality of LED chips can deliver more than approximately 200 LPW at 1W and 25 °C.

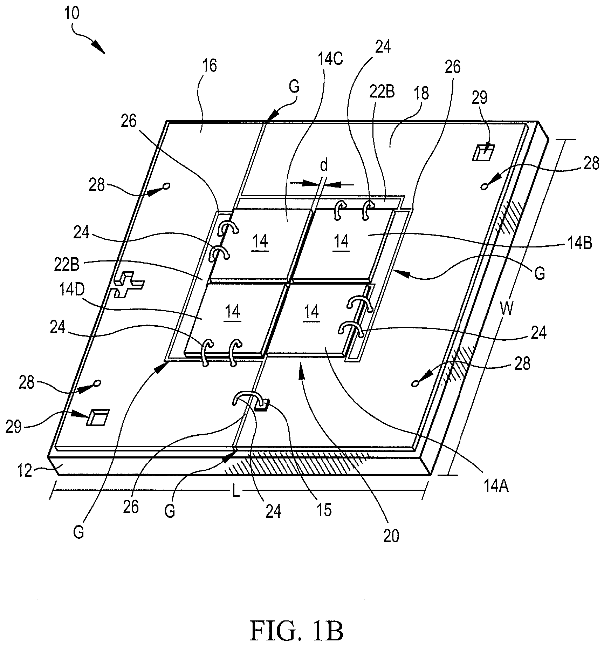

Figures 1A and 1B collectively illustrate embodiments of a light emitter package generally designated **10**. Light emitter package **10** can comprise a substrate or submount **12** and at least one LED chip **14** disposed over attached to, and/or supported by submount **12**. Figure 1A illustrates a pattern of traces disposed over submount **12,** to which a plurality of LED chips can attach. LED chips **14** are illustrated as attached in Figure 1B.

Submount **12** can comprise any suitable material, for example, an electrical insulating (e.g. non-electrically conductive) material with a low thermal resistance and/or high thermal conductivity. Submount **12** can comprise a substrate that has been singulated from a large, continuous panel of material. In one aspect, submount **12** can comprise a non-metallic material, such as a ceramic or ceramic based material. For example, submount **12** can comprise aluminum oxide or alumina (Al₂O₃) and derivatives thereof, aluminum nitride (AIN) and derivatives thereof, silicon carbide (SiC) and derivatives thereof, zirconium dioxide or zirconia (ZrO₂) and derivatives thereof, titanium dioxide (TiO₂) and derivatives thereof, combinations thereof, and/or any other ceramic based or ceramic containing material.

In one aspect, AIN may be preferred as it can advantageously comprise a low thermal resistance. Material(s) having a low thermal resistance can be advantageous when provided as submount **12**, as heat can more readily dissipate from each LED chip **14** and allow light emitter package **10** to run cooler at steady state, thereby increasing lumen output. In some aspects, submount **12** can comprise a continuous piece of material from the center of package **10** to the edge of package **10**, and is not merely a "frame" for the package as used in conventional designs. Using a single, continuous piece of material can lower manufacturing costs as extraneous processing steps for creating the "frame" can be eliminated. In addition, extra materials such as silicone must be provided for embedding a panel into a frame, thus, such extra materials such as silicone embedded in the panel can be obviated by using the continuous, single material submount **12** described herein.

Submount **12** can comprise a material having a thermal conductivity of approximately 30 watts per meter kelvin (W/m•K) or more (e.g., zinc oxide (ZnO)). Other acceptable materials have thermal conductivities of approximately 120 W/m•K or more, (e.g., AIN which has a thermal conductivity that can range from approximately 140 to approximately 180 W/m•K). In terms of thermal resistance, some acceptable materials have a thermal resistance of approximately 2° C/W or lower. Other materials may also be used that have thermal characteristics outside the ranges discussed herein.

Submount **12** can comprise a thickness between approximately 0.25 and 1.25 millimeters (mm) as measured between uppermost and bottommost surfaces of submount **12**. For example, submount **12** can comprise a thickness of approximately 0.25 to 0.5 mm; approximately 0.5 mm; approximately 0.5 to 0.75 mm; and/or approximately 0.75 to 1.25 mm. Submount **12** can comprise any suitable shape, for example, such as a square, rectangle, circular, non-circular, regular, irregular, and/or asymmetrical shape. It is further understood that submount **12** and outer perimeter of package **10** can comprise any shape, as viewed from above, including square, non-square, rectangular, circular, non-circular, asymmetrical, or other multi-sided shapes.

In one aspect, submount **12** can for example comprise a substantially square shape having a length **L** and a width **W** of approximately 5.0 mm or more. For example and without limitation, submount **12** can comprise a substantially square shape of the following length **L** and width **W** dimensions, respectively: approximately 5.0 mm x 5.0 mm (e.g., an area of approximately 25 mm²); approximately 6.0 mm x 6.0 mm (e.g., an area of approximately 36 mm²); approximately 7.0 mm x 7.0 mm (e.g., an area of approximately 49 mm²); approximately 9 x 9 mm (e.g., an area of approximately 81 mm²); approximately 9.1 x 9.1 mm (e.g., an area of approximately 82.8 mm²); and/or length(s) **L** and/or width(s) **W** of more than approximately 10 mm x 10 mm. In one aspect, a submount **12** comprising an area equal to and/or greater than approximately 49 mm² (e.g., 7 mm x 7 mm) package size can be used and preferred. Submounts **12** of any shape, such as rectangular or circular can also be provided.

As Figures 1A and 1B further illustrate, one or more areas or portions of electrically conductive material can be disposed over one or more portions of submount **12**. For example, a first electrically conductive trace **16** and a second electrically conductive trace **18** can be provided and disposed over submount **12**. First and second traces **16** and **18**, respectively, can be physically and/or electrically separated by one or more trenches or gaps generally designated **G.**

In some aspects as illustrated in Figure 1A, one or more areas or portions of electrically conductive material can also be deposited between portions of first trace **16** and second trace **18**. For example and in some aspects, a plurality of traces, generally designated **20** can be disposed between first trace **16** and second trace **18**. The plurality of traces **20** can comprise more than one individual trace **22** separated by one or more gaps **G**. In some aspects, each individual trace **22** can be adapted to attach to a portion of at least one LED chip **14** as illustrated in Figure 1B. In some aspects, at least one individual trace **22** can extend from portions of first trace **16** and/or at least one individual trace **22** can extend from portions of second trace **18** as illustrated in Figure 1A. Some individual traces **22** can be physically and/or electrically separated from each of first trace **16** and second trace **18** via one or more gaps **G**. In some aspects, each individual trace **22** and first and second traces **16** and **18**, respectively, can comprise one or more layers of titanium (Ti), copper (Cu), and/or silver (Ag). In some aspects, one or more optional layers of electroless nickel immersion gold (ENIG) can also be applied over portions of traces for improving the wirebondability of light emitters, such as LED chips (Figure 1B), to the trace layers of material.

In some aspects, first and second traces **16** and **18** can, but do not have to, be the same material or materials as the plurality of traces **20**. In some aspects, first and second traces **16** and **18**, respectively, and the plurality of traces **20** can be provided over submount **12** via chemical deposition, physical deposition, chemical vapor deposition, plasma deposition, electrolysis, electroplating and/or electroless plating techniques. In one aspect, any suitable processing technique can be used for coating non-metallic parts (e.g., submount **12**) with electrically conductive material. In some aspects, first and second traces **16** and **18**, and the plurality of traces **20**, comprised of electroless metals deposited via electroless processes, may be desired as such techniques can advantageously produce traces having more uniform thicknesses as compared to other methods. Any method of layering, coating, and/or depositing conductive material over submount **12** for providing first and second traces **16** and **18**, respectively, as well as the plurality of traces **20** is contemplated.

In some aspects, one or more trenches or gaps **G** can be disposed between adjacent individual traces **22** within the plurality of traces **20**. Trenches or gaps **G** can be chemically or physically etched, mechanically formed via physical or mechanical removal of material, and/or otherwise formed. Any method of forming trenches or gaps **G** between individual traces **22** and/or first and second traces **16** and **18** is contemplated.

In some aspects, package **10** can comprise a multi-trace device adapted to receive a plurality of LED chips **(14**, Figure 1B). In some aspects, gaps **G** can be disposed between portions of first trace **16** and the plurality of traces **20**. In some aspects, gaps **G** can be disposed between portions of second trace **18** and the plurality of traces **20**. In some aspects, first and second traces **16** and **18** can be peripherally disposed about the plurality of traces **20**. That is, in some aspects the plurality of traces **20** can be centrally disposed over submount **12** and surrounded by portions of first and second traces **16** and **18**.

In some aspects, the plurality of traces **20** can comprise a substantially square shaped area which is substantially centrally disposed over submount **12**. In other aspects, the plurality of traces **20** can comprise a substantially circular shaped area which is substantially centrally disposed over submount **12**. In some aspects, placing a plurality of LED chips (**14**, Figure 1B) over the plurality of centrally disposed traces **20** can improve thermal management within package **10**, as heat generated by the plurality of centrally disposed LED chips can dissipate more readily from the center to the edges of the package submount **12**. In addition, heat can spread away from the center of the package **10**.

As illustrated in Figure 1A and in some aspects, some individual traces **22** can comprise a square and/or rectangular shaped portion **22A** adapted to attach and/or electrically communicate with a light emitter, such as an LED chip (**14**, Figure 1B). For example, at least one light emitter can be disposed over each square or rectangular shaped portion **22A** and can directly attach and directly electrically communicate with the individual trace **22** via an electrically conductive paste, solder material, adhesive, flux material, or epoxy.

In some aspects, one or more leg portions **22B** can extend from the rectangular or square shaped portions **22A** of some individual traces **22**. The leg portions **22B** can be smaller in width and/or thinner than the rectangular or square shaped portions **22A** of some individual traces **22**. In some aspects, electrical signal or current can pass into a plurality of light emitters disposed over individual traces **22** and/or can pass between first and second traces **16** and **18**, in part, by serially connecting LED chips via wirebonds **24** to adjacent leg portions **22B** of individual traces **22**. Each rectangular and/or square shaped portion **22A** of some individual traces **22** within the plurality of traces **20** can be, but do not have to be the same size. Each rectangular and/or square shaped portion of some individual traces **22** within the plurality of traces **20** can be, but does not have to be the same shape. In some aspects, a combination of rectangular and square shaped light emitters (e.g., LED chips **14**, Figure 1B) can be used in package **10**. In some aspects, only square light emitters can be used in package **10**. In certain other aspects, only rectangular shaped light emitters can be used in package **10**.

Rectangular and/or square shaped portions **22A** of individual traces **22** can include any suitable size and can vary with respect to the size and/or shape of LED chip or chips used. For example and in some aspects, square shaped portions **22A** of some individual traces **22** can have length and width dimensions that are at least approximately 300 µm x 300 µm (e.g., an area of 900 µm² or more); at least approximately 500 µm x 500 µm (e.g., an area of approximately 0.25 mm² or more); at least approximately 700 µm x 700 µm (e.g., an area of approximately 0.49 mm² or more); at least approximately 1000 µm x 1000 µm (e.g. 1 mm x 1 mm, or an area of at least 1 mm² or more); at least approximately 1350 µm x 1350 µm (e.g., 1.35 mm x 1.35 mm or an area of at least 1.8 mm² or more); and/or greater than approximately 1500 µm x 1500 µm (e.g., 1.5 mm x 1.5 mm or an area of 2.25 mm² or more).

As noted earlier, the plurality of traces **20** can comprise a mix of square and rectangular portions of any suitable size can be provided over submount **12**. In some aspects, only square or only rectangular portions of some individual traces **22** may be provided as only square or only rectangular light emitters may be provided. LED chips **14** can comprise any suitable dimension, size, and/or shape. For example, square and/or rectangle LED chips **14** having straight cut and/or bevel cut sides are contemplated herein.

In some aspects, light emitter package **10** can comprise a plurality of light emitters that are each a same size. In other aspects, light emitters of different sizes (large and small) can be used together within package **10**. As such, different sizes and/or shapes of individual traces **22** within the plurality of traces **20** can be provided. In some aspects, individual traces **22** can comprise square shaped portions, rectangular shaped portions, non-square shaped portions, non-rectangular shaped portions, circular shaped portions, asymmetrically shaped portions, symmetrically shaped portions, combinations thereof, and/or any other suitably shaped and/or sized portions.

In some aspects, each LED chip **14** of the plurality of chips can be adapted to emit a same general color of light. In some aspects, LED chips **14** can be adapted to emit distinctly different colors of light. LED chips **14** can emit any one color or any combination of colors including for example, primarily green, cyan, blue, red, orange, amber, yellow and/or white light emitters can be provided. In one aspect, LED chips **14** can comprise similar and/or different targeted wavelength bins including red, blue, green, amber, red-orange, and/or combinations thereof.

Referring to Figure 1B, a plurality of LED chips **14** can be provided over the plurality of traces **20**. In some aspects, each LED chip **14** can be entirely disposed over a portion of one individual trace **22** without traversing and/or being disposed over any portion of any gap **G.** That is, LED chips **14** can electrically communicate with at least two traces, including one of first trace **16**, second trace **18**, and/or one of the plurality of traces **22** via a combination of direct die attach and electrical connectors, such as wirebonds **24.** In some aspects, each LED chip **14** can comprise a vertically structured chip having an electrical terminal on a bottom surface of the chip for directly attaching and electrically communicating with the underlying trace. Each LED chip **14** can also comprise one or more electrical terminals on an opposing upper surface of the chip for electrically communicating to a portion of another trace via wirebonds **24**. For example, as shown, each LED chip **14** can comprise two bond pads disposed on the upper surface of the chip for wirebonding to traces via wirebonds **24**. In some aspects, LED chips **14** can be vertically structured such that the electrical terminal disposed on the bottom of the LED chip is a different electrical polarity than the bond pads. In some aspects, each bond pad on the upper surface of each LED chip **14** can be the same electrical polarity.

As Figure 1B illustrates, a first LED chip **14A** can be disposed over at least one individual trace **22** that can extend from a portion of second trace **18**. First LED chip **14A** can electrically communicate with another individual trace, for example, an adjacent leg portion **22B** of an adjacent individual traced **22**, via wirebonds **24**. Electrical signal can then pass into a second, serially connected LED chip **14B** via square or rectangular portion **22A** of the adjacent individual trace **22**. Second, third, and fourth LED chips **14B**, **14C**, and **14D**, respectively, can be disposed over second, third, and fourth individual traces **22**. Each of the LED chips **14** can be serially connected within package **10**. Fourth LED chip **14D** can be disposed adjacent to first LED chip **14A**, and can be wirebonded to a portion of first trace **16.** At least two, four, or more than four LED chips **14** can be provided within package **10**.

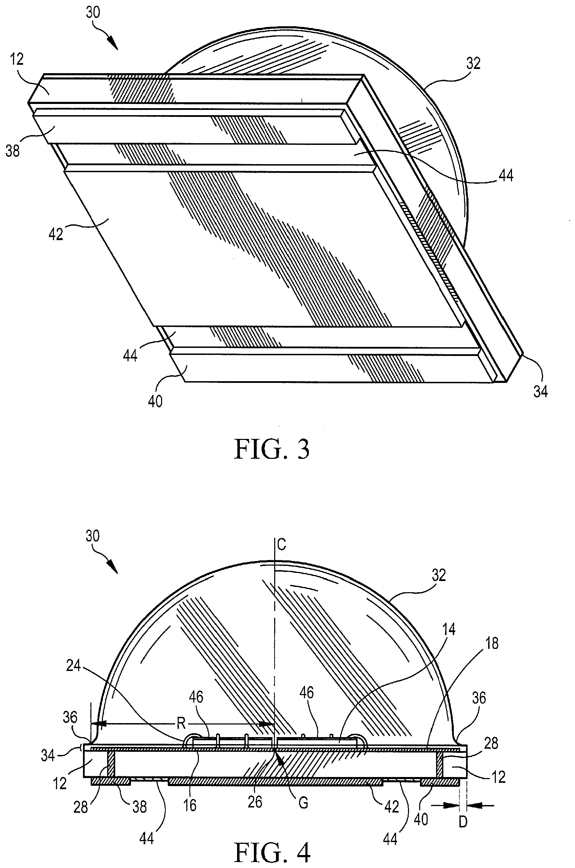

In one aspect, first and second electrical traces **16** and **18**, respectively, can comprise an anode and cathode pair configured to pass electrical current or signal into the plurality of LED chips **14**. For example, electrical current can be conducted through and/or within submount **12** from an outside electrical power source (not shown) into one or more electrical contacts (e.g., **38**, **40**, Figure 3) and respective traces **16** and **18** by electrically conductive "through-holes" or "vias" **28** which provide a conduit for electrical current within light emitter package **10**. The electrical current can then flow or pass between first and second traces **16** and **18** and into a plurality of serially connected LED chips **14** thereby causing illumination of each LED chip **14**. Electrical current can then exit light emitter package via at least one electrical contact (e.g., **38** or **40**, Figure 3).

In one aspect, first electrical trace **16** can comprise an anode as denoted by the "+" shaped indicator symbol or sign and second electrical trace **18** can comprise a cathode. Notably, each LED chip **14** can comprise a novel chip structure and electrical configuration, as LED chips **14** can be serially connected between one LED chip directly attach to a cathode, e.g., second trace **18**, and one LED chip wirebonded to an anode, e.g., first trace **16**. That is, LED chips **14** within package **10** can be reverse biased and/or opposite in electrical polarity from typical LED chips.

Provision of LED chips **14** wirebonded to a portion of an anode and mounted to a portion of a cathode is unexpected in view of conventional wisdom, and in fact, is the opposite electrical configuration from conventional LED chips (e.g., conventional chips are typically mounted over the cathode and wirebonded to the anode). In one aspect, LED chips **14** described herein are available from Cree, Inc., of Durham, N.C., the assignee of the present subject matter, the LED chip structures, features, and associated methods of which are set forth in, for example, U.S. Patent Application Serial No. 13/168,689, filed June 24, 2011, and entitled "LED Structure With Enhanced Mirror Reflectivity", the entire disclosure of which is incorporated herein by reference.

Notably, wirebonds **24** extending form each LED chip **14** can be positioned towards an outer periphery of the plurality of chips, or extend towards an outer edge of submount **12**. This can further improve light extraction, as wirebonds **24** are not disposed towards a center of the plurality of LED chips **14** where they could block, absorb, or otherwise interfere with light. Wirebonds **24** can comprise any electrically conducive material, such as, for example and without limitation, gold (Au) or an alloy containing Au. Wirebonds **24** can also include Al, Sn, or Ag. As noted above, a first novel LED chip **14A** can be mounted, either directly or indirectly, over a portion of the cathode, for example, a portion of second electrical trace **18** via a silicone material or epoxy, a metal epoxy (e.g., Ag epoxy), a solder, solder paste (e.g., AuSn or SnAg solder paste), a flux material, a eutectic material, combinations thereof, and/or any other suitable adhesive material. A second novel LED chip (e.g., **14D**) can be wirebonded to an anode.

The plurality of LED chips **14** can comprise chips that are uniformly spaced apart from each other, chips that are non-uniformly spaced apart from each other, or combinations thereof. That is, some LED chips **14** can be spaced close to some LED chips and farther away from some other chips. In some aspects, each edge of each LED chip **14** can be equidistant to adjacent chip(s). In some aspects, chips can be spaced apart by at least a distance **d**. In some aspects, distance **d** can correlate to an improved brightness of package **10**. That is, distance **d** can be optimized for maximum, improved brightness, such that light does not become trapped within gaps **G** and/or become blocked or absorbed by adjacent chips or components within package **10**.

In some aspects, adjacent LED chips **14** can be spaced close to gaps **G,** but not traverse across a portion of any gap **G**. In some aspects, distance **d** can be slightly larger than a width of one or more gaps **G**. In some aspects, distance **d** can be approximately 0.03 mm or more; approximately 0.05 mm or more; approximately 0.06 mm or more (e.g., approximately 60 µm or more); approximately 0.10 mm or more; approximately 0.30 mm or more; approximately 0.50 mm or more; or more than approximately 0.625 mm. In some aspects, distance **d** can be between approximately 0.06 mm and 0.3 mm, however, distances of more than 0.3 can be provided.

Notably, packages disclosed herein can for example average more than approximately 100 LPW at 1W and 25° C, such as approximately 145 LPW at 1W and 25 °C in selected color temperatures between approximately 2700 K and 7000 K and/or between approximately 2700 K and 5000 K. In some aspects, packages disclosed herein can average more than approximately 180 LPW at 1W and 25 °C. As these numbers are averages, and as discussed further below, packages disclosed herein can deliver approximately 200 LPW or more at 1W and 25 °C. LED chips **14** can be spaced apart at any distance **d** between and/or any sub-ranges of a distance **d** between approximately 0.010 mm and 1 mm, such as any distance approximately equal to or greater than 0.06 mm.

One or more electrostatic discharge (ESD) protection devices **15** can optionally be disposed within package **10** and can be electrically connected to first and second **16** and **18** via wirebond **24** and reverse biased with respect to the plurality of serially connected LED chips **14**. Where used, ESD device **15** can protect against damage from ESD within package **10**. For example, the arrangement of LED chips **14** and ESD device **15** can allow excessive voltage and/or current passing through package **10** from an ESD event to pass into and/or through ESD device **15** instead of LED chips **14,** thereby protecting LED chips **14** from damage. ESD device **15** can comprise any suitable body or member configured to protect package **10** from an ESD event. For example, ESD device **15** can comprise a vertical silicon (Si) Zener diode, a differently dimensioned and/or smaller LED chip arranged reverse biased to LED chips **14,** a surface mount varistor, and/or a lateral Si diode. As illustrated, ESD device **15** can comprise a vertically structured device having one electrical contact on the bottom and another electrical contact on the top; however, a horizontally structured ESD device **15** can also be provided.

Notably, first and second traces **16** and **18** can comprise layers of exposed metal for improving reflection and/or light extraction from package **10**. In some aspects, each individual trace **22** of the plurality of traces **20** can comprise layers of exposed metal. In one aspect, first and second traces **16** and **18** as well as the plurality of traces **20** comprised of exposed metal can advantageously reflect more light than underlying submount **12**, which can improve brightness, light extraction, and performance from light emitter package **10**. Notably, leaving metallic traces exposed (e.g., uncovered, such as without a reflective material, a solder mask, or any other masking material) can also decrease processing steps and/or materials consumed during manufacture, which results in a lower cost. In some aspects, first and second traces **16** and **18** and the plurality of traces **20** can comprise metallic reflectors which are specularly reflective. As described below, gaps **G** disposed between adjacent traces (e.g., **16, 18,** and **22**) can be at least partially filled with a diffusively reflective material **26** to further improve light extraction. Reflective material **26** can be applied using any technique, such as dispensing in gaps **G**.

In one aspect, first and second traces **16** and **18** and the plurality of traces **20** can each comprise a Cu layer, either directly or indirectly disposed over submount **12**. The Cu layer can comprise a thickness ranging for example from approximately 20 µm to approximately 100 µm, and/or any sub-range therebetween, such as approximately 20 to 50 µm; approximately 50 to 55 µm; approximately 55 to 65 µm; approximately 65 to 75 µm; approximately 75 to 85 µm; and/or approximately 85 to 100 µm. In one aspect, the Cu layer can for example comprise an overall average thickness of approximately 70 µm. First and second traces **16** and **18**, respectively and the plurality of traces **20** can further comprise an optional, initial layer of Ti that can be deposited directly over submount **12** prior to deposition of the Cu layer. Where used, the Ti layer can comprise a thickness ranging from approximately 0.01 to 1 µm, and/or any sub-range or thickness therebetween, such as approximately 0.01 to 0.05 µm; 0.05 to 0.1 µm; and/or 0.1 to 1 µm. In one aspect, the Ti layer can comprise a thickness or overall thickness of approximately 0.1 µm. First and second traces **16** and **18**, respectively and the plurality of traces **20** can further comprise an optional layer of Ag that can be deposited, or otherwise formed, directly over the Cu layer such that the Cu layer is disposed between the Ti and Ag layers. Where used, the Ag layer can comprise a thickness from approximately 0.1 to 1 µm, and/or any sub-range therebetween, such as approximately 0.1 to 0.2 µm; 0.2 to 0.5 µm; 0.5 to 0.8; and/or 0.8 to 1 µm.

Referring to Figures 1A and 1B in general and as noted above, light emitter package **10** comprises at least one trench or gap **G** disposed between the anode and cathode, such as between first and second traces **16** and **18**, respectively. A plurality or network of gaps **G** can also be disposed between first trace **16**, second trace **18**, and individual traces **22** within the plurality of traces **20**. Gaps **G** can physically and electrically separate portions of first and second traces **16** and **18**, respectively, portion of first trace and individual traces **16** and **22**, respectively, and/or portions of second trace and individual traces **18** and **22**, respectively.

Gaps **G** can be formed using any suitable technique. In one aspect, gaps **G** can be at least partially etched after deposition or application of material forming first and second traces **16** and **18** and the plurality of traces **20**. That is, first and second traces **16** and **18** and/or each of the plurality of traces **20** can initially comprise a uniform area or portion of conductive material comprised of one or more layers of metallic material. The layers of metallic material can subsequently become at least partially etched, thereby separating first trace **16** from second trace **18** and individual traces **22** from the plurality of traces **20** via gaps **G**. In further aspects, gap **G** can comprise an area of submount **12** that was masked with photoresist prior to sputtering conductive material over submount **12** to provide first and second traces **16** and **18** and the plurality of traces **20**.

Notably, a reflective material **26** is positioned in, disposed in, and/or otherwise configured to fill the space within gap **G**, such that reflective material **26** is disposed between portions of first and second traces **16** and **18**, respectively. In some aspects, reflective material **26** can be disposed between opposing side walls of first and second traces **16** and **18**. Reflective material **26** can also be disposed between portions of first trace **16** and at least one trace of the plurality of traces **20** and between second trace **18** and at least one trace of the plurality of traces **20**. Each individual trace **22** of the plurality of traces can be separated by a trench or gap **G** which can be at least partially filled with reflective material **26**.

In one aspect, reflective material **26** disposed within gaps **G** can comprise a white material, a silver material, a plastic material, a Lambertian coating, a dispensable material, any reflective coating, and/or a mask material, such as a solder mask. In some aspects, reflective material **26** can comprise a white or silver-white liquid curable solder mask. Reflective material **26** can advantageously fill gap **G** thereby reducing the amount of light that may become trapped and/or absorbed by gap **G**, which can improve the brightness and overall optical performance of emitter package **10**. According to the invention, reflective material **26** is applied only within gap **G** and not over portions of any traces (e.g., including first trace **16**, second trace **18**, and/or any trace of the plurality of traces **20**) such that the amount of solder mask material used per package can be reduced or minimized, which can advantageously lower the cost of light emitter package **10**.

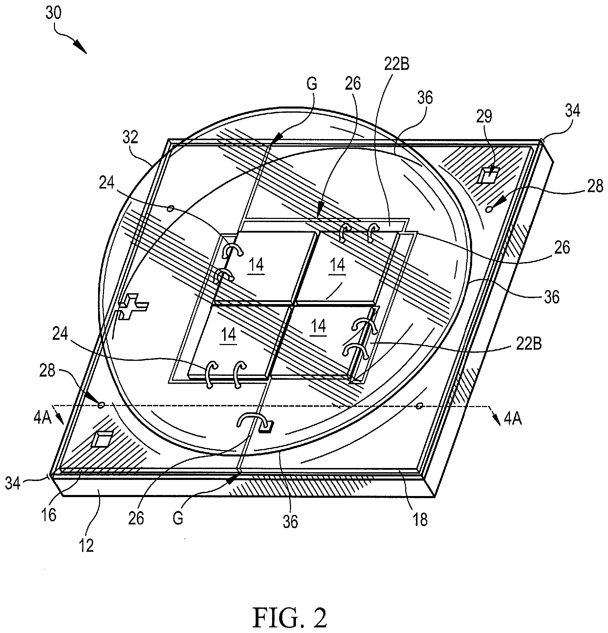

As noted above, first and second traces **16** and **18** can comprise an anode and cathode, respectively, which can be disposed over first and second portions of submount **12**. Reflective material **26** can in one aspect be disposed over a third portion of submount **12**, where the third portion of submount **12** can optionally be disposed between the first and second portions of submount **12**, such as between opposing first and second traces **16** and **18**, respectively. According to the invention, reflective material **26** is only disposed within gaps **G**, such that first and second traces **16** and **18**, respectively and the plurality of traces **20** comprise areas of exposed metal disposed directly below and/or outside portions of a lens (e.g. **32**, Figure 2). In some aspects, reflective material **26** can be disposed between adjacent LED chips **14**. This novel placement of reflective material between chips, when combined with the exposed metal traces, chip spacing, and/or novel LED chip **14** configuration, (e.g., LED chips mounted to a cathode and wirebonded to an anode), improves reflection, light emission, brightness, and overall performance of light emitter package **10**.

Still referring to Figures 1A and 1B in general, light emitter component **10** can further comprise one or more through-holes filled with electrically conductive material, or electrically conductive vias **28**. Electrically conductive vias **28** can extend internally through and/or within submount **12** between a first bottom contact (e.g., **38** Figure 4) and first trace **16** and between a second bottom contact (e.g., **40**, Figure 4) and second trace **18**. Light emitter package **10** can further comprise one or more alignment areas **29** or fiducials that can be used to help with registration and/or alignment of light emitter package **10** during fabrication and processing.

Notably, light emitter package **10** can exhibit improved light output, reliability, and efficacy by delivering, for example, up to and/or more than approximately 200 LPW at 1W and approximately 25 °C in selected color temperatures, for example, CW color temperatures around 6000 K, WW color temperatures around 3000 K, or any temperature therebetween. Package **10** and/or systems incorporating package **10** can advantageously deliver more LPW at a lower cost than other existing packages or systems. Packages **10** can also advantageously use multiple light emitters, or multiple LED chips as opposed to a single chip. This can increase efficiency of package **10**, as multiple chips can be manufactured less expensively than single, high brightness and large chips. Thus, multiple chips can advantageously lower manufacturing costs and increase efficiency. The multiple chips disposed centrally within package **10** can also advantageously comprise a small optical source with a high lumen density, thus improving optical control and color consistency. Optical control can be important, for example, in outdoor directional lighting applications where control is needed to more efficiently utilize light by illuminating only where needed. Shining light in places that are not needed can be wasteful and inefficient.

Novel features of the plurality of LED chips **14** (e.g., at least one LED chip mounting to a cathode and at least one other LED chip wirebonding to an anode), when combined with exposed or uncovered metallic traces, improved chip spacing, and/or placement of reflective material, such as solder mask, within a portion of trenches or gaps **G** is shown to improve package **10** brightness and efficiency. In one aspect, LED chips **14** can comprise alternating p-GaN and n-GaN layers which, in part, advantageously allow for one or more smaller barrier layers to be provided adjacent one or more highly reflective mirrors. In one aspect, the one or more barrier layers can be smaller in width than the mirror layers. Notably, this can advantageously allow for increased light extraction and/or brightness per LED chip **14**, as decreasing the size of the barrier layer(s) can allow for barrier layer(s) that is/are minimally exposed and/or not exposed, thereby reducing the dimming effects of the barrier layer(s). Thus, packages **10** comprising LED chips **14** can be configured to deliver more LPW per package, for example, approximately 145 LPW or more at 1W and 25 °C, approximately 180 LPW or more at 1W and 25° C, and/or approximately 200 LPW or more at 1W and approximately 25 °C.

LED chips **14** described herein are available from Cree, Inc., of Durham, N.C., the assignee of the present subject matter, the LED chip structures, features, and associated methods of which are set forth in, for example, U.S. Patent Application Serial No. 13/168,689, filed June 24, 2011 which has previously been incorporated herein by reference.

Figure 2 illustrates a second embodiment of a light emitter package, generally designated **30**. Light emitter package **30** is similar in form and function to package **10**; however, light emitter package **30** can further comprise an optical element. An optical element can comprise any member or material configured to produce light output of a desired shape and/or position light in a desired direction, and can comprise a layer of encapsulant and/or a lens **32**. A protective layer **34** can extend from portions of lens **32**, for example, outwardly from portions of a lens base **36**, and can be configured to extend over submount **12**, and up to outermost edges of submount **12**.

In some aspects, at least a portion of lens **32** can be disposed over portions of first and second traces **16** and **18**, respectively, and the plurality of traces **20**, each of which can comprise areas of exposed metal. Optical element or lens **32** can be formed on a top surface of submount **12** and can be centrally disposed or centrally aligned over a center of the plurality of LED chips **14** and/or a center of submount **12**, such that an apex, or area of maximum height, can be aligned over the center of the plurality of LED chips **14** (see e.g., Figure 4) and/or the center of submount **12**. In other aspects, lens **32** can be non-centrally disposed (e.g., off-center) with respect to the center of the plurality of LED chips **14** and/or the center of submount **12**. Lens **32** can provide both environmental and/or mechanical protection of package components, such as LED chips **14**, wirebonds **24**, and/or exposed metallic traces, such as first and second traces **16** and **18** and each of the plurality of traces **20**. In some aspects, package can include an overall maximum height from the electrical contacts to the apex of lens **32**. The overall height can be approximately 3 mm or more, approximately 3.5 mm or more, approximately 4 mm or more, or greater than approximately 4 mm.

In some aspects, lens **32** can comprise any material, such as an epoxy, plastic, glass, and/or silicone material, and can be provided using any method, such as encapsulating or molding. Lens **32** can comprise an overmolded lens, and comprise any suitable shape depending on the desired shape of the light output. One suitable shape as shown is hemispheric, where lens **32** comprises a substantially circular lens base **36**. Notably, portions of first and second traces **16** and **18**, respectively, each of which can comprise areas of exposed metal, can at least partially and/or substantially be disposed over a portion of submount **12** that is outside of lens base **36**. Thus, the exposed metallic traces can advantageously reflect light by covering a large portion of submount **12** and can extend over substantial portions of submount **12** that are under or below lens **32** and lens base **36** as well as substantial portions of submount **12** that are outside of lens base **36** (e.g., towards corners, below protective layer **34**). First and second traces **16** and **18** and/or the plurality of traces **20** can, but do not have to extend to the outermost edges of submount **12**. For example, as shown, first and second traces **16** and **18** do not extend to all the way flush with the outermost edges of submount **12**.

A lens having a non-hemispheric or circular cross-sectional and/or base shape is also contemplated herein, such as an ellipsoid bullet shaped lens, flat lens, hex-shaped lens and/or lens base, and/or square shaped lens and/or lens base. In one aspect, lens **32** can comprise a silicone material that is suitable for molding and can provide suitable optical transmission properties. It can also withstand subsequent reflow processes and does not significantly degrade over time. It is understood that lens **32** can also at least partially be textured to improve light extraction and/or be coated with or contain optical conversion, light scattering, and/or reflective materials such as phosphors or light scattering particles.

As noted above, protective layer **34** can substantially cover the top surface of submount **12** and extend between edges of lens base **36** and one or more edges of submount **12**. Protective layer **34** can provide additional protection for components of light emitter package **30**, such as LED chips **14**, traces (e.g., **16**, **18**, and **20**) reflective material **26** and/or wirebonds **24**. Protective layer **34** can further reduce damage and/or contamination such as grease or debris during subsequent processing steps and use. For example, protective layer **34** can protect first and second traces **16** and **18** and/or ESD protection device **15** from peeling and/or lifting during processing. Protective layer **34** can be formed during formation of lens **32** and can comprise the same or different material as lens **32**. It is understood, however, that package **30** can also be provided without protective layer **34**. It is understood that the lens arrangement of light emitter package **30** can easily be adapted for use with a secondary lens or optics that can be included over lens **32** by the end user to facilitate beam shaping. These secondary lenses are generally known in the art, with many of them being commercially available.

Protective layer **34** can optionally comprise one or more markings (not shown), for example, notches and/or ridges associated with the mold block and/or molding process. For example and in one aspect, optional channels can be formed or disposed in the mold block which forms lens **32** and protective layer **34**. Such channels can reduce and/or prevent air bubbles from occurring in the lens encapsulant during the molding process, and can also prevent under filling. Channels can cause markings (e.g., notches or ridges, not shown) over or on portions of protective layer **34**, and can further ensure that a cover film (not shown) used during the molding process sits into the lens cavity properly. Channels can advantageously create an easier path for air under the film to escape. The film cover can be used to cover the mold block to reduce or prevent silicone from settling into the mold. However, if all the air is not removed from between the film cover and mold block, an under filled lens will be observed. The channels can increase the airflow under the film and allow all the air to flow out before the film was sealed to the frame. Thus, optional channels in the mold block can advantageously prevent and/or reduce observed under filling, but may leave remnant type markings (not shown) over portions of lens **32** and/or protective layer **34**.

Figure 3 is a bottom perspective view of light emitter package **30**. Package **30** can comprise first and second electrical contacts **38** and **40** adapted to pass electrical signal or current into first and second traces **16** and **18**, respectively, causing illumination of LED chips **14** (Figure 2). First and second electrical contacts **38** and **40** can comprise metallized areas for receiving electrical signal from an external source (not shown), for example, an electrical circuit, a PCB, a metal core printed circuit board (MCPCB), a circuit of a lighting system, a flex circuit, a heat sink, combinations thereof, and/or any other source adapted to transfer electrical current.

In some aspects, first and second electrical contacts **38** and **40** can for example comprise at least one layer of Cu, and optional layers of Ti and/or Ag. The at least one layer of Cu can comprise a thickness ranging from approximately 50 µm to approximately 100 µm, and/or any sub-range therebetween, such as approximately 50 to 55 µm; 55 to 65 µm; approximately 65 to 75 µm; approximately 75 to 85 µm; and/or approximately 85 to 100 µm. In one aspect, the Cu layer can comprise an overall average thickness of approximately 70 µm. Where used, the optional Ti layer of contacts **38** and **40** can be disposed between the submount **12** and Cu layer, and can comprise a thickness ranging from approximately 0.01 to 1 µm, and/or any sub-range or thickness therebetween, such as approximately 0.01 to 0.05 µm; 0.05 to 0.1 µm; and/or 0.1 to 1 µm. In one aspect, the Ti layer can comprise a thickness or overall thickness of approximately 0.1 µm.

First and second contacts **38** and **40,** respectively, can further comprise an optional layer of Ag that can be deposited, or otherwise formed, directly over the Cu layer such that the Cu layer is disposed between the Ti and Ag layers. Where used, the Ag layer can comprise for example a thickness from approximately 0.1 to 1 µm, and/or any sub-range therebetween, such as approximately 0.1 to 0.2 µm; 0.2 to 0.5 µm; 0.5 to 0.8; and/or 0.8 to 1 µm.

First and second electrical contacts **38** and **40** can be disposed on a surface of submount **12** that is opposite of placement of first and second traces **16** and **18**, the plurality of traces **20**, and/or the plurality of LED chips **14**. For example, first and second electrical contacts **38** and **40** can be disposed on a bottom surface of submount **12** and first and second electrical traces can be disposed on the top surface of submount **12**. Electrically conductive vias **28** (Figures 1, 2, and 4) can be disposed between portions of and/or electrically connect first and second electrical contacts **38** and **40** to first and second traces **16** and **18**, respectively. Electrical current can then pass between first and second contacts **38** and **40** to first and second traces **16** and **18**, respectively, for illumination of the serially connected LED chips **14** (Figure 2) when electrical energy is converted into light.

A current or electrical signal can be applied through first and second electrical contacts **38** and **40** from an external source (not shown) when package **30** mounts over external source. For example, first and second electrical contacts **38** and **40** can electrically communicate to solder contacts or other conductive paths located on the external source (not shown), and pass current into first and second traces **16** and **18**, respectively. An external source can comprise any suitable external source capable of conveying or passing electrical current into package **30**. In the embodiment shown, light emitter package **30** can be arranged for mounting using surface mount technology and device **30** can comprises internal conductive paths defined by one or more conductive vias **28** (also shown in Figures 4A and 4B). First and second electrical contacts **38** and **40** can at least partially align with first and second electrical traces **16** and **18**, respectfully.

Still referring to Figure 3, emitter package **30** can further comprise a thermal element **42** disposed over the bottom surface of submount **12**. Thermal element **42** can optionally be disposed between first and second electrical contacts **38** and **40**, respectively. In one aspect, thermal element **42** can be disposed in a central location of submount **12** below the one or more of the plurality of LED chips **14** (Figures 2 and 4). Thermal element **42** can comprise any thermally conductive material and can be in at least partial vertical alignment with LED chips **14** (Figures 2 and 4). In one embodiment, thermal element **42** can be electrically separated from electrical traces **16** and **18** on top surface of submount **12** as well as first and second contacts **38** and **40** bottom surface of submount **12**. Although heat from LED chips **14** can laterally spread over the top surface of submount **12** via traces (e.g., first and second traces **16** and **18** and plurality of traces **20**, Figure 2), more heat can pass into submount **12** directly below and around the plurality of LED chips **14**. Thus, thermal element **42** can assist with heat dissipation by allowing heat to spread into thermal element **42** where it can dissipate more readily from the package **30**.

For packages or device used in surface mount technology, the thickness of thermal element **42** and first and second electrical contacts **38** and **40** can be approximately the same such that all three make contact to a lateral surface such as a PCB. To improve wetting of the solder however, and to ensure a more robust contact between thermal element **42** and an external heat sink, thermal element **42** may extend away from the body of the package **30** to a greater distance than first and second electrical contacts **38** and **40**. That is, it is contemplated that thermal element **42** can be thicker than first and second electrical contacts **38** and **40**.

Notably, areas or portions of electrically and/or thermally insulating material, such as areas of solder mask material **44**, can be provided between thermal element **42** and each of first and second electrical contacts **38** and **40**. In one aspect, solder mask **44** can comprise a green color, and can be approximately 1 to 25 µm thick, and any sub range thereof, such as approximately 1 to 5 µm; approximately 5 to 10 µm; approximately 10 to 13 µm; approximately 13 to 15 µm; approximately 15 to 20 µm; and/or approximately 20 to 25 µm.

Referring now to Figure 4, a sectional view of light emitter package **30** can be seen. For example, the sectional view can be disposed along line **4A-4A** of Figure 2. As Figure 4 illustrates, one or more conductive vias **28** can extend through submount **12** between first electrical contact **38** and first electrical trace **16** for passing electrical signal therebetween. Similarly, one or more conductive vias **28** can be formed extending between second electrical contact **40** and second trace **18** such that when an electrical signal is applied to second contact **40** it can be conducted through submount **12** and into second trace **18** and into a first LED chip, and passed into the other serially connected LED chips. Conductive vias **28** can comprise any suitably electrically conducting material, such as Ag, Cu, Au, Pt, or any other metal or metal alloy and can be applied using any suitable technique. As conductive vias **28** physically and/or electrically connect respective electrical contacts (e.g., **38** and **40**) and respective traces (e.g., **16** and **18**), it is understood that electrical contacts and/or traces may be positioned in other arrangements, including adjacent or lateral arrangements, in addition to the arrangement illustrated.

Conductive vias **28** can form between electrical contacts (e.g., **38** and **40**) and respective traces (e.g., **16** and **18**) and can be substantially vertically and/or non-vertically arranged. For example, in some aspects conductive vias **28** can be arranged at an angle within submount **12**. It is also understood that instead of vias **28**, one or more intervening metallic or conductive layers and/or contacts can be provided between one or more surfaces of the submount **12** between electrical contacts (e.g., **38** and **40**) and respective traces (e.g., **16** and **18**), even, for example, along external lateral surfaces of submount **12**.

As Figure 4 further illustrates, reflective material **26** (shown in black for clarity purposes) can be at least partially disposed within gap **G** between portions of first trace **16** and second trace **18**. First and second traces **16** and **18** can comprise areas of exposed metal, such as exposed Cu, Ti, Ag, and/or ENIG materials or layers as previously described. First and second traces **16** and **18** can generally occupy a large surface area of submount **12** and can be disposed about a plurality of traces **20**. Each trace of the plurality of traces **20** can be separated by a trench or gap **G**. Reflective material **26** can be disposed in each trench or gap **G**. In some aspects, first and second traces **16** and **18**, as well as the plurality of traces **20**, can cover the substantial majority of the area between the outermost edges of submount **12**. Each trace can comprise areas of exposed metal which can extend across the majority of submount **12**, including areas outside of lens base **36**. By extending traces in this manner, the amount of heat which can be dissipated or spread away from LED chips **14** can be improved. Thermal dissipation of heat generated in LED chips **14** can thus be improved, which improves the operating life and reliability of package **30**. Improved thermal properties can also allow for a higher operating power of LED chips **14** and light emitter package **30**.

Lens **32** of light emission package **30** can comprise a lens base **36** having a radius **R** which extends from approximately the centerline **C** of lens **32** to an edge defined by lens base **36**, or where lens base **36** intersects with protective layer **34**. In one aspect, the centerline **C** of lens **32** can correspond to the centerline of package **30** and/or the centerline of the plurality of LED chips **14,** however, centerline **C** of lens **32** can also be off-center with respect to either the centerline of package **30** or the centerline of LED chips **14**. Lens **32** can comprise a wide viewing angle, such as approximately 120° or more, such as approximately 125°.

In one aspect, lens can **32** comprise a substantially circular shaped lens base **36** disposed over a substantially square shaped submount **12** such that a diameter of lens **32** (e.g., 2x**R**) can be similar to length **L** and/or width **W** of submount **12**. Lens base **36** can comprise radius **R** of approximately 1 to 8 mm (e.g., and a lens base area of approximately 3 mm² to 113 mm²) and/or any number or sub-range thereof. For example, lens base **36** can comprise radius **R** that is approximately equal to or greater than 1 mm; approximately equal to or greater than 2 mm; approximately equal to or greater than approximately 3 mm; approximately equal to or greater than approximately 3.25 mm; approximately equal to or greater than approximately 4 mm; or greater than approximately 4 mm. In one aspect, lens **32** can comprise an overmolded lens having a lens base **36** area of approximately 30 mm² or more, for example, approximately 33.2 mm². In some aspects, lens can comprise an optical source of approximately 6 mm in diameter, disposed over and supported by an approximately 7 mm x 7 mm package or submount **12**. In some aspects, package **30** can provide a small optical source having a high lumen density, excellent color consistency, and superior optical control.

In some aspects, a distance **D** can be disposed between lens base **36** and an outermost edge of submount **12**. Notably, lens **32** can comprise a large size or shape adapted to improve and/or maximize brightness and light extraction. In some aspects, lens **32** almost extends fully to outermost edges of submount **12**. In some aspects, distance **D** can be approximately 0.05 mm or more, approximately 0.1 mm or more, approximately 0.15 mm or more, or more than 0.2 mm. In some aspects, distance **D** is approximately 0.25 mm.

Notably, the novel combination of LED electrical configuration, exposed metal traces, improved chip-to-chip spacing, placement of reflective material in gaps, and/or radius **R** of lens base **36** can contribute to improved performance of light emitter package **30**. Notably, light emitter package **30** can combine high light output, reliability and efficacy to deliver up to approximately 145 or more LPW at 1W and 25 °C and up to approximately 180 or more LPW at 1W and 25 °C in selected color temperatures, for example in CW color temperature of approximately 6000K. Light emitter package **30** can also deliver up to approximately 200 LPW or more at 1W and 25 °C using multiple chips provided at an improved lower cost, in part by eliminating costly materials and/or processing steps associated by using exposed metal traces and a minimal amount of solder mask disposed therebetween.

As further illustrated by Figure 4, an optical conversion material **46** can be disposed over each LED chip **14**. In some aspects optical conversion material **46** is disposed over the entire surface of each LED chips **14,** such that material **46** fully covers an upper surface of each LED chip **14**. Notably, optical conversion material **46** can be applied prior to die attach of each LED chip **14,** thereby minimizing required processing steps, minimizing an amount of phosphor consumed, as well as reducing processing time and cost. Thus in some aspects, optical conversion material **46** may restricted to application over LED chips **14** only, and may not be applied over other package components. Optical conversion material **46** can comprise one or more binders, phosphors, lumiphors, or a phosphor or lumiphor containing material and binder applied via any suitable technique. In one aspect, optical conversion material **46** can be sprayed or dispensed over LED chips **14** prior to die attach. In one aspect, optical conversion material **46** can absorb at least some of the light emitted from LED chips **14** and can in turn emit light having a different wavelength such that light emitter package **30** emits a combination of light from the LED chips **14** and phosphor. In one aspect, light emitter package **30** can emit light that is perceived as white light of approximately 2700 to 7000 K, such as CW light around 6000 K, CW light around approximately 5500 K, neutral white light around 4100 K, or WW light around 3000 K.

In one aspect, one or more LED chips **14** selected for use can comprise wavelengths targeting cool white (CW) or warm white (WW) light upon, for example, mixing with light emitted from the phosphors or a phosphor containing material. Any suitable wavelength bin and/or phosphor combination can be selected depending upon the application and desired light emission. Phosphors can be adapted to emit light that is yellow, green, red, and/or combinations thereof upon absorbing light emitted by LED chips **14**. Packages shown and described herein can be available at any color temperature and/or color temperature bin, for example CW temperatures in the E5 and E7 (e.g., a minimum of 70, 80, & 90 CRI) chromaticity bins.

In some aspects, advancements in LED chip **14** structure, chip spacing, package design, exposed metallic traces, and/or placement of reflective material can deliver the most advanced LED components in the industry, and can allow light emitter package **30** to deliver between approximately 145 LPW and 200 LPW at 1W and 25 °C or more than 200 LPW at 1W and 25 °C at selected color temperatures. In some aspects, light emitter packages, systems, and/or methods described herein can deliver up to approximately 2050 Im at 15W and 25 °C in CW temperatures of around 6000 K.

In some aspects, light emitter packages and/or systems shown and described herein are ENERGY STAR® qualified and ENERGY STAR® compliant. ENERGY STAR® is an international standard for energy efficient consumer products originated in the United States of America. ENERGY STAR® qualification is awarded to only certain products that meet strict efficiency, quality, and lifetime criteria. For example, ENERGY STAR® qualified LED lighting can use at least 75% less energy than incandescent lighting, save on operating expenses, reduces maintenance costs (e.g., last 35 to 50 times longer than incandescent lighting and about 2 to 5 times longer than fluorescent lighting), and reduce cooling cost. To qualify for ENERGY STAR® certification, LED lighting products must pass a variety of tests to prove that the products will display following characteristics such as having, *inter alia*, (i) a brightness equal to or greater than existing lighting technologies (incandescent or fluorescent), (ii) light that is well distributed over the area lighted by the fixture, (iii) light output remains constant over time, (iv) excellent color quality with a shade of white light that appears clear and consistent over time, (v) no flicker when dimmed, and (vi) no power use when the product is turned off.

In some aspects, packages and systems shown and described herein can also be UL® recognized. That is, packages **10** and **30** as described herein can be level 4 enclosure recognized, which is the highest rating possible. Level 4 enclosure recognition indicates that light emitter packages **10** and **30** have been investigated as a fire and electrical enclosure per ANSI/UL 8750. This can advantageously save consumer's time and money, therefore, advantageously promote the adoption of LED products.

In general, light emitter packages, systems, and/or methods disclosed herein can be used in indoor and outdoor high-lumen applications including indoor directional lighting applications, outdoor lighting applications, and be adapted to provide halogen replacement lamps. For example, light emitter packages, systems, and/or methods herein can provide parabolic aluminized reflector (PAR) lamps, track lighting, GU10 halogen bulbs or products, multifaceted reflector (MR) light bulbs or products, roadway lighting, parking area lighting, high and low bay lighting, or any other high-lumen or higher efficacy LED lighting products or LED applications.

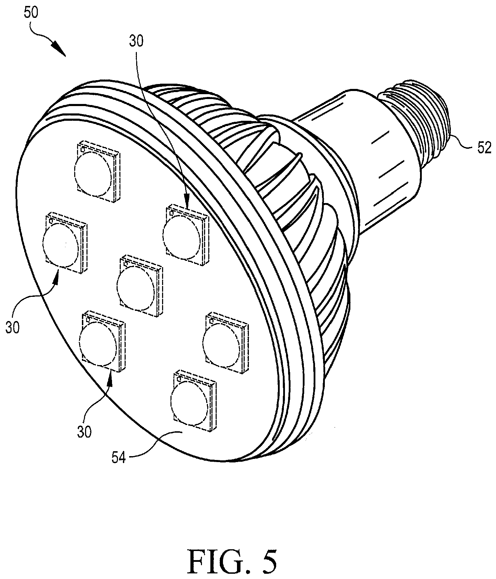

Figure 5 is a light emitter system, generally designated **50**, which can incorporate one or more light emitter packages **30** according to the disclosure herein. Packages **30** are indicated in phantom lines as they may be placed within or below a portion of a lens, bulb, or other optical component of system **50**, and may not be visible externally. In some aspects, only a single light emitter package **30** can be used within a single component or single system **50**. That is, in some aspects, a single package **30** can be equivalent to a 60 W light bulb. In other aspects, a plurality of packages **30** can be used in system **50**. Light emitter system **50** can comprise any lamp or bulb used in directional, low and high bay, roadway and parking, high end lighting, indoor lighting, outdoor lighting, portable lighting, and/or off-grid lighting. In one aspect, system **50** comprises a PAR lamp.

System **50** can comprise a base **52** adapted to plug into a socket or circuit for receiving electrical energy used for light conversion. System **50** can further include a light emitter portion **54** from which light can be emitted by one or more light emitter packages **30**. Packages **30** can be oriented as shown, such that light from at least one package **30** can be directly emitted from the light emitter portion **54**. In other aspects, packages **30** can be oriented towards base **52** such that light from at least one package **30** can be emitted towards base **52** and reflected back out from light emitter portion **54** via an internal reflective surface (not shown). System **50** can be configured to incorporate one, or more than one light emitter packages **30**.

Notably, at least one light emitter package **30** can be used to upgrade an existing system **50**, such that, for example, system **50** can be upgraded from a 60 W or 75 W equivalent lamp to a 90 W or 100 W equivalent lamp in one step. Packages 30 described herein can be more efficient at 10 W than conventional packages, and can be operable using a 12 V platform, thereby allowing for more efficient power supplies. Light emitter packages **30** can advantageously be designed to conform to existing system **50** dimensions, while being brighter and more efficient at a lower cost such that the improved packages can replace emitters within existing systems without requiring a redesign of system **50**.

In some aspects, consumers can easily incorporate at least one package **30** into lighting systems, such as system **50**, for an immediate boost in performance at a lower cost and/or lower power consumption. In one aspect, light emitter package **30** can be configured to drop-in to system **50** allowing for an easy upgrade to different, brighter, and/or more efficient emitter in one simple step. Packages **30** and systems described herein can be available over and/or be configured to deliver a range of color temperatures from WW to CW, for example, from approximately 2700 to 7000K. Packages **30** and systems described herein can also be available in various CRI options

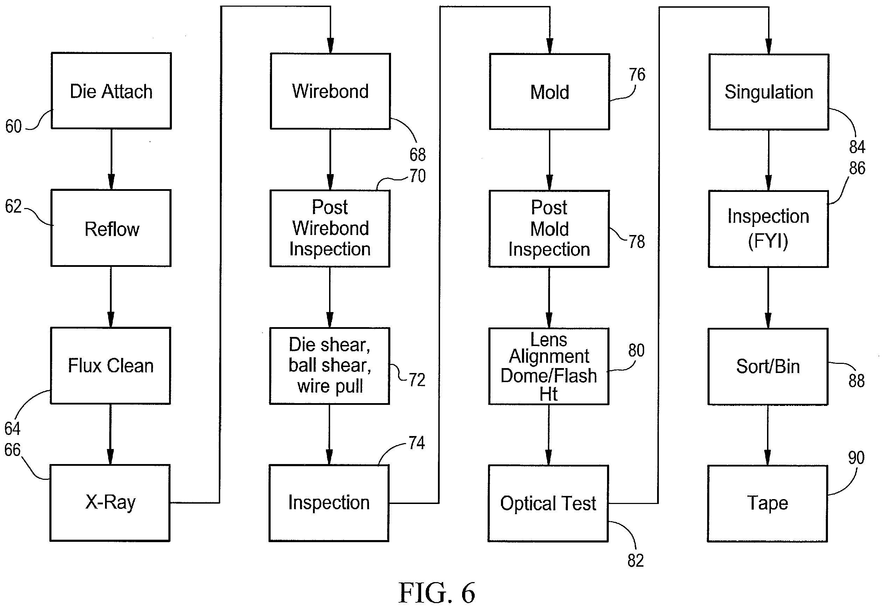

Figure 6 is an embodiment of a method for providing light emitter packages and/or systems described herein. As previously described, a plurality of LED chips can be pre-applied or pre-coated with an optical conversion material, such as phosphor, prior to die attach. In step **60**, the LED chips can then be die attached to a portion of traces which have been deposited, or otherwise applied, over a panel substrate of ceramic material. The panel substrate can comprise a ceramic material, such that individual package submounts can comprise the same material across the package, and may not include a package frame. The panel substrate with LED chips can subsequently be reflowed in step **62**. In step **64** the panel substrate with LED chips can be cleaned to remove die attachment material, such as flux. In step **66** the panel substrate can be x-rayed for inspection purposes.

As further illustrated in step **68**, LED chips can be wirebonded. At least one LED chip can be wirebonded to the cathode portion of what will be the emitter package upon singulation (e.g., step **84**). In step **70**, the substrate can be inspected post-wirebonding to check for adequate electrical connection between each LED chip and the traces. In step **72**, at least one LED chip can be tested via die shear, ball shear, and/or wire pull testing procedures to ensure adequate chip bonding, and to assure LED chips are not from a defective batch. In step **74**, the substrate can be inspected prior to molding the optical element, such as prior to molding the lens.

As illustrated in Figure **76**, a plurality of optical elements, such as lenses, can be overmolded on the panel substrate. The lenses can comprise liquid curable silicone. In step **78**, each lens can be inspected post-molding to ensure that the lens is adequately molded and/or positioned thereon. In step **80**, lens alignment can be verified. In step **82**, the panel substrate with LED chips can be tested for optical and/or electrical properties, such as brightness and Vf.

As illustrated in step **84**, individual packages can then be singulated from the panel substrate. In step 86, each package can be inspected post singulation. In step **88**, each package can be sorted and binned per optical or electrical properties such as brightness, color, voltage and/or combinations thereof. In step **90**, the packages can be put on tape for shipping to customers for incorporation into lighting systems.

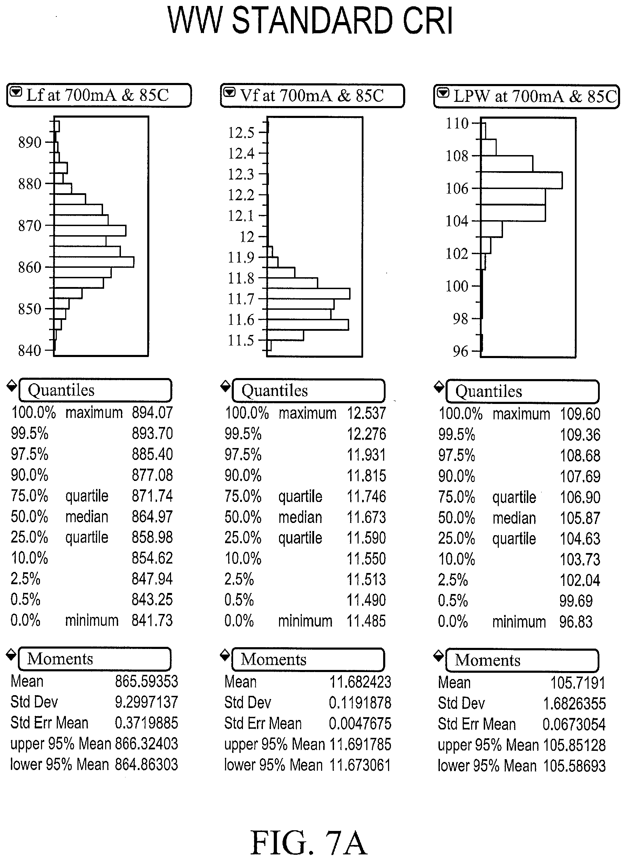

Figures 7A to 9 are graphical illustrations of light output, brightness data (e.g., lumens (Ims) or lumens per Watt (LPW)), and forward voltage (Vf) data associated with light emitter packages and/or systems described herein. Notably, packages disclosed herein can comprise multiple and/or a plurality of LED chips. This can contribute to packages and systems having a lower cost (e.g., not required to produce a single, high brightness chip as packages can rely on multiple chips for achieving brightness), a higher efficiency, improved optical control, a small form factor, improved reflection, as well as improved color consistency.

In some aspects, specifications for packages and/or systems described herein can include operation at a current of 700 mA and a voltage of 12 V, and a binning temperature of approximately 85 °C. In other aspects, packages and/or systems described herein can include operation at 1W and a voltage of approximately 11 to 12 V, and a binning temperature of approximately 25 °C. Color targets can comprise an E2 chromaticity bin (e.g., CW, about 5700 K and about 70 CRI typical), an E5 chromaticity bin (e.g., CW or neutral white, about 4000 K and about 75 or 80 CRI typical), and/or an E7 chromaticity bin (e.g., WW, about 3000 K and about an 80 or 85 CRI typical).

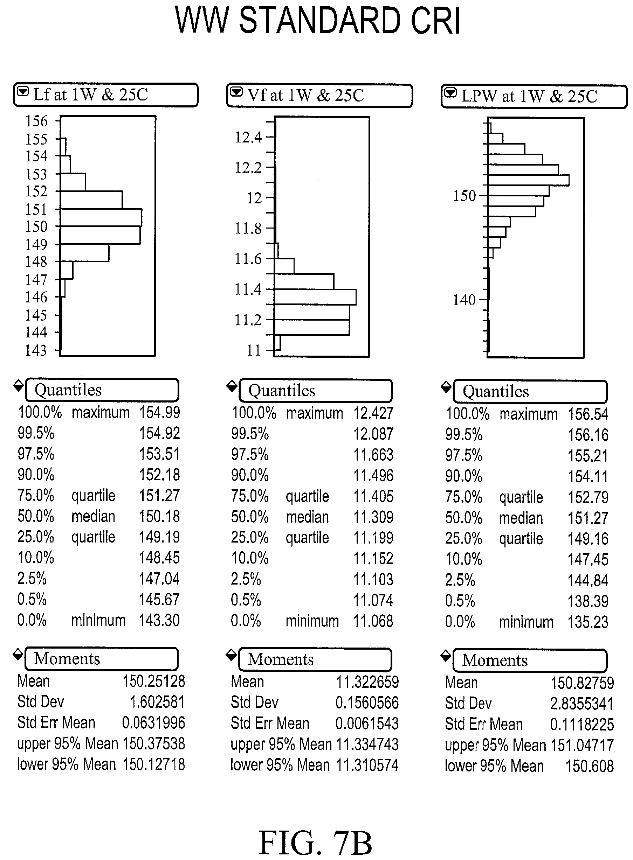

Figures 7A and 7B illustrate distributions of brightness and Vf data for packages and/or systems having a WW color temperature in a standard CRI bin (e.g., 80 or 85 minimum and/or typical). The data in Figure 7A depicts measurements at 700 mA and approximately 85 °C. The data in Figure 7B depicts measurements at 1W and approximately 25 °C. In some aspects, Figures 7A and 7B illustrate data for packages and/or systems having a WW color temperature within a standard E7 bin. As noted above, the standard E7 bin can include WW packages or systems having a color temperature of approximately 3000 K or more, and typically an 80 or 85 CRI. In some aspects, WW packages and/or systems can comprise a minimum of 80 or 85 CRI.

Referring to Figure 7A and as the left most distribution indicates, packages disclosed herein can have a perceived output or luminous flux (Lf) of between approximately 840 and 890 Ims at 700 mA and 85 °C. In some aspects, packages disclosed herein can deliver more than approximately 840 Ims, such as approximately 865 Ims or more, approximately 870 Ims or more, or more than approximately 890 Ims at 700 mA and 85 °C.

As the middle distribution in Figure 7A indicates, packages having a WW color temperature can be operable at approximately 11.5 V or more, such as between approximately 11.5 and 12 V at 700 mA and 85 °C. In some aspects, packages having a WW color temperature can be operable at approximately 11.7 V on average at 700 mA and 85 °C.

The distribution on the right of Figure 7A indicates the brightness of packages and/or systems having a WW color temperature in a standard CRI bin (e.g., 80 or 85 CRI minimum and/or 80 or 85 CRI typical) when measured at 700 mA and 85 °C. In some aspects, packages and/or systems having a WW color temperature can deliver more than approximately 100 LPW at 700 mA and 85 °C. In some aspects, packages and/or systems having a WW color temperature can deliver more than approximately 102 LPW, more than approximately 106 LPW, or more than approximately 108 LPW at 700 mA and 85 °C.

Referring now to Figure 7B, multi-chip packages and/or systems described herein can have a perceived output or Lf of between approximately 145 and 157 Ims at 1W and 25 °C. In some aspects, packages disclosed herein can deliver more than approximately 145 Ims, such as approximately 150 Ims or more, approximately 152 Ims or more, or more than approximately 155 lms at 1W and 25 °C.

As the middle distribution in Figure 7B indicates, packages having a WW color temperature can be operable at approximately 11 V or more, such as between approximately 11 and 12 V at 1W and 25 °C. In some aspects, packages having a WW color temperature can be operable at approximately 11.3 V on average at 1W and 25 °C.

The distribution on the right of Figure 7B indicates brightness of packages and/or systems having a WW color temperature in a standard CRI bin at 1W and 25 °C. In some aspects, packages and/or systems having a WW color temperature can deliver more than approximately 140 LPW at 1W and 25 °C. In some aspects, packages and/or systems having a WW color temperature can deliver more than approximately 148 LPW, more than approximately 150 LPW, and/or more than approximately 155 LPW at 1W and 25 °C. In some aspects, packages and/or systems having a WW color temperature can deliver between approximately 145 LPW and 157 LPW at 1W and 25 °C, such as between approximately 150 and 157 LPW at 1W and 25 °C.

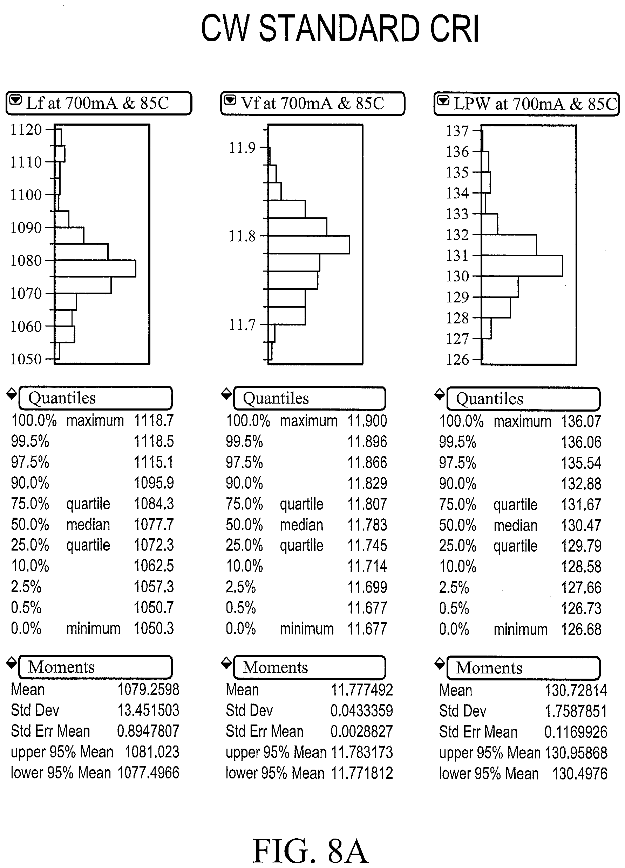

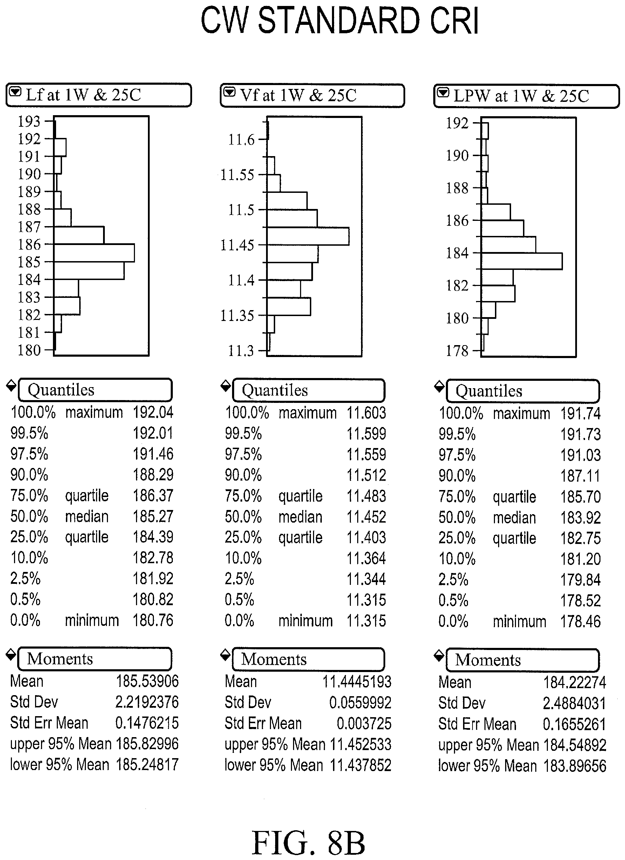

Figures 8A and 8B illustrate distributions of brightness and Vf data for packages and/or systems having an cool white (e.g., "CW") color temperature in a standard CRI bin (e.g., approximately 70 CRI or a minimum of 70 CRI). The data in Figure 8A depicts measurements at approximately 700 mA and 85 °C. The data in Figure 8B depicts measurements at approximately 1W and 25 °C. In some aspects, Figures 8A and 8B illustrate data for packages and/or systems having a CW color temperature within a standard E2 CRI bin. As noted above, the standard E2 chromaticity bin can include CW packages or systems having a color temperature of approximately 5700 K or more, and typically 70 CRI. In some aspects, CW packages and/or systems can comprise a minimum of 70 CRI.

Referring to Figure 8A and as the left most distribution indicates, packages disclosed herein can have a perceived output or Lf of between approximately 1050 and 1120 Ims at 700 mA and 85 °C. In some aspects, packages disclosed herein can deliver more than approximately 1050 Ims, such as approximately 1070 Ims or more, approximately 1080 Ims or more, or more than approximately 1100 Ims at 700 mA and 85 °C.

Still referring to Figure 8A and as the middle distribution indicates, packages having a CW color temperature can be operable at approximately 11.6 V or more, such as between approximately 11.6 and 12 V at 700 mA and 85 °C. In some aspects, packages having a CW color temperature can be operable at approximately 11.8 V on average at 700 mA and 85 °C.

The distribution on the right of Figure 8A indicates brightness of packages and/or systems having a CW color temperature in a standard CRI bin (e.g., 70 CRI typical and/or minimum) at 700 mA and 85 °C. In some aspects, packages and/or systems having a CW color temperature can deliver more than approximately 127 LPW at 700 mA and 85 °C. In some aspects, packages and/or systems having a CW color temperature can deliver more than approximately 130 LPW, more than approximately 132 LPW, or more than approximately 135 LPW at 700 mA and 85 °C.

Referring now to Figure 8B, lower cost, more efficient multi-chip packages and/or systems described herein can have a perceived output or Lf of between approximately 180 and 193 Ims at 1W and 25 °C. In some aspects, packages disclosed herein can deliver more than approximately 182 Ims, such as approximately 185 Ims or more, approximately 188 Ims or more, or more than approximately 190 Ims at 1W and 25 °C.

As the middle distribution of Figure 8B indicates, packages and/or systems having a CW color temperature can be operable at approximately 11.3 V or more, such as between approximately 11.3 and 11.7 V at 1W and 25 °C. In some aspects, packages having a CW color temperature can be operable at approximately 11.5 V on average at 1W and 25 °C.

The distribution on the right of Figure 8B indicates brightness of packages and/or systems having a CW color temperature binned at 1W and 25 °C. In some aspects, packages and/or systems having a CW color temperature can deliver more than approximately 180 LPW at 1W and 25 °C. In some aspects, packages and/or systems having a CW color temperature can deliver more than approximately 182 LPW, more than approximately 184 LPW, and/or more than approximately 186 LPW at 1W and 25 °C. In some aspects, packages and/or systems having a CW color temperature can deliver between approximately 180 LPW and 192 LPW at 1W and 25 °C, such as between approximately 182 and 192 LPW at 1W and 25 °C.

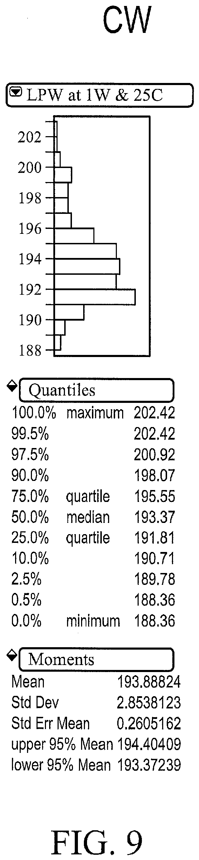

Figure 9 illustrates a further distribution of brightness, for packages and/or systems described herein as measured at 1W and approximately 25 °C. In some aspects, packages having characteristics similar to that shown in Figure 9 can comprise multiple novel LED chips as described in, for example, co-pending and commonly assigned U.S. Patent Application Serial No. 13/168,689 which has been previously incorporated by reference herein. In some aspects, LED chips used within packages can have a distribution similar to Figure 9 having improved barrier layers as described in Figure 14 of co-pending and commonly assigned U.S. Patent Application Serial No. 13/168,689.

As Figure 9 indicates, novel light emitter packages and/or systems as described herein can deliver more than approximately 200 LPW at 1W and 25 °C at selected color temperatures, such as CW color temperatures. As Figures 9 illustrates, packages and/or systems having a CW color temperature can deliver more than approximately 188 LPW, more than approximately 194 LPW, and/or more than approximately 198 LPW at 1W and 25 °C. In some aspects, packages and/or systems having a CW color temperature can deliver between approximately 188 LPW and 203 LPW at 1W and 25 °C, such as between approximately 192 and 203 LPW at 1W and 25 °C. Notably, such packages and/or systems can exhibit improved brightness, light extraction, and overall improved optical properties.

Embodiments as disclosed herein may provide one or more of the following beneficial technical effects: reduced cost of manufacturing light emitter packages; improved brightness from light emitter packages; improved light extraction from light emitter packages; reduced processing time associated with manufacturing light emitter packages; reduced materials required for producing light emitter packages; improved optical control; small footprint providing a narrow beam for improved optical control; improved two-step binning; 100+ LPW high lumen directional systems; small optical source having a high lumen density; excellent color consistency; use as a single component in indoor directional lighting applications which better emulates the single filament appearance of incumbent lighting products than multiple package designs; improved, smaller form factor; improved indoor and outdoor directional lighting systems; and/or improved thermal properties of light emitter packages. While the subject matter has been has been described herein in reference to specific aspects, features, and illustrative embodiments, it will be appreciated that the utility of the subject matter is not thus limited, but rather extends to and encompasses numerous other variations, modifications and alternative embodiments, as will suggest themselves to those of ordinary skill in the field of the present invention, based on the disclosure herein. Various combinations and sub-combinations of the structures and features described herein are contemplated and will be apparent to a skilled person having knowledge of this disclosure. Any of the various features and elements as disclosed herein may be combined with one or more other disclosed features and elements unless indicated to the contrary herein. Correspondingly, the invention as hereinafter claimed is intended to be broadly construed and interpreted, as including all such variations, modifications and alternative embodiments, within its scope.

## Claims

1. A light emitter package (10) comprising:
a submount (12) comprising an anode (16) and a cathode (18), wherein a gap (G) is disposed between the anode (16) and the cathode (18);
a plurality of light emitter diode chips (14) disposed over the submount (12), wherein each of the light emitter diode chips (14) is electrically connected to the anode (1) and the cathode (18); and **characterized in that**
a reflective solder mask material (26) disposed only in the gap (G) for increasing an amount of light emitted by the light emitter package (10), wherein a light emitter chip (14) of the plurality of light emitter chips (14) is wirebonded to at least a portion of the anode.

2. The light emitter package (10) of claim 1, wherein the package (10) is configured to deliver up to approximately 145 or more lumens per watt (LPW) when operated at 1W of electrical power and at a binning temperature of approximately 25 °C.

3. The light emitter package (10) of claim 1, wherein the package (10) is configured to deliver up to approximately 180 or more lumens per watt (LPW) when operated at 1W of electrical power and at a binning temperature of approximately 25 °C.

4. The light emitter package (10) of claim 1, wherein the package (10) is configured to deliver up to approximately 200 or more lumens per watt (LPW) when operated at 1W of electrical power and at a binning temperature of approximately 25 °C.

5. The light emitter package (10) of claim 1, wherein the reflective solder mask material (26) comprises a white solder mask material (26).

6. The light emitter package (10) of claim 1, further comprising an optical conversion material (46) disposed over each chip (14) of the plurality of chips (14).

7. The light emitter package (10) of claim 6, wherein the optical conversion material (46) comprises phosphor, and wherein the phosphor is only disposed over each chip (14) of the plurality of chips (14).

8. The light emitter package (10) of claim 1, wherein the package (10) is configured to deliver a range of color temperatures from approximately 2700 to 7000K when activated by electrical current.

9. The light emitter package (10) of claim 1, wherein a first and a second light emitter diode chips (14) are spaced apart by at least approximately 0.025 mm or more.

10. The light emitter package (10) of claim 1, wherein the submount (12) comprises an area of approximately 49 mm² or more.

11. The light emitter package (10) of claim 1, wherein the submount (12) comprises a thermal conductivity equal to or greater than approximately 30 watts per meter kelvin (W/m•K).

12. A method of providing a light emitter package (10), the method comprising:
providing a substrate (12) comprising an anode (16) and a cathode (18), wherein a gap (G) is disposed between the anode (16) and the cathode (18);
providing a first light emitter diode chip (14) and a second light emitter diode chip (14) over the submount (12), wherein the first and the second light emitter diode chips (14) are electrically connected to the anode (16) and the cathode (18); and **characterized by**
providing a reflective solder mask material (26) only in the gap (G) for increasing an amount of light emitted by the light emitter package (10).

13. The method of claim 12, further comprising providing a string of serially connected light emitter diode chips (14) between the first and second light emitter diode chips (14).

14. The method of claim 12, further comprising providing an optical conversion material (46) directly over portions of each light emitter diode chip (14).

## Patentansprüche

1. Lichtemitter-Package (10), umfassend:
einen Submount (12), der eine Anode (16) und eine Kathode (18) umfasst, wobei ein Spalt (G) zwischen der Anode (16) und der Kathode (18) angeordnet ist;
mehrere Leuchtdiodenchips (14), die über dem Submount (12) angeordnet sind, wobei jeder der Leuchtdiodenchips (14) mit der Anode (1) und der Kathode (18) elektrisch verbunden ist; und
**dadurch gekennzeichnet, dass**
ein reflektierendes Lötstoppmaskenmaterial (26) nur in dem Spalt (G) angeordnet ist, um eine Menge an Licht, das durch das Lichtemitter-Package (10) emittiert wird, zu erhöhen, wobei ein Leuchtdiodenchip (14) der mehreren Leuchtdiodenchips (14) mit mindestens einem Abschnitt der Anode drahtgebondet ist.

2. Lichtemitter-Package (10) nach Anspruch 1, wobei das Package (10) eingerichtet ist, um bis zu ungefähr 145 oder mehr Lumen pro Watt (LPW) zu liefern, wenn es mit einer elektrischen Leistung von 1 W und einer Binning-Temperatur von ungefähr 25 °C betrieben wird.

3. Lichtemitter-Package (10) nach Anspruch 1, wobei das Package (10) eingerichtet ist, um bis zu ungefähr 180 oder mehr Lumen pro Watt (LPW) zu liefern, wenn es mit einer elektrischen Leistung von 1 W und einer Binning-Temperatur von ungefähr 25 °C betrieben wird.

4. Lichtemitter-Package (10) nach Anspruch 1, wobei das Package (10) eingerichtet ist, um bis zu ungefähr 200 oder mehr Lumen pro Watt (LPW) zu liefern, wenn es mit einer elektrischen Leistung von 1 W und einer Binning-Temperatur von ungefähr 25 °C betrieben wird.

5. Lichtemitter-Package (10) nach Anspruch 1, wobei das reflektierende Lötstoppmaskenmaterial (26) ein weißes Lötstoppmaskenmaterial (26) umfasst.

6. Lichtemitter-Package (10) nach Anspruch 1, ferner umfassend ein optisches Umwandlungsmaterial (46), das über jedem Chip (14) der mehreren Chips (14) angeordnet ist.

7. Lichtemitter-Package (10) nach Anspruch 6, wobei das optische Umwandlungsmaterial (46) Leuchtstoff umfasst und wobei der Leuchtstoff nur über jedem Chip (14) der mehreren Chips (14) angeordnet ist.

8. Lichtemitter-Package (10) nach Anspruch 1, wobei das Package (10) eingerichtet ist, um einen Bereich von Farbtemperaturen von ungefähr 2700 bis 7000 K zu liefern, wenn es durch elektrischen Strom aktiviert wird.

9. Lichtemitter-Package (10) nach Anspruch 1, wobei ein erster und ein zweiter Leuchtdiodenchip (14) um mindestens ungefähr 0,025 mm oder mehr voneinander beabstandet sind.

10. Lichtemitter-Package (10) nach Anspruch 1, wobei der Submount (12) einen Bereich von ungefähr 49 mm² oder mehr umfasst.

11. Lichtemitter-Package (10) nach Anspruch 1, wobei der Submount (12) eine Wärmeleitfähigkeit von größer oder gleich ungefähr 30 Watt pro Meter und Kelvin (W/m•K) umfasst.

12. Verfahren zum Vorsehen eines Lichtemitter-Packages (10), wobei das Verfahren umfasst:
Vorsehen eines Substrats (12), das eine Anode (16) und eine Kathode (18) umfasst, wobei ein Spalt (G) zwischen der Anode (16) und der Kathode (18) angeordnet ist;
Vorsehen eines ersten Leuchtdiodenchips (14) und eines zweiten Leuchtdiodenchips (14) über dem Submount (12), wobei der erste und der zweite Leuchtdiodenchip (14) mit der Anode (16) und der Kathode (18) elektrisch verbunden sind; und
**gekennzeichnet durch**
Vorsehen eines reflektierenden Lötstoppmaskenmaterials (26) nur in dem Spalt (G), um eine Menge an Licht, das durch das Lichtemitter-Package (10) emittiert wird, zu erhöhen.

13. Verfahren nach Anspruch 12, ferner umfassend Vorsehen eines Strangs in Reihe geschalteter Leuchtdiodenchips (14) zwischen dem ersten und dem zweiten Leuchtdiodenchip (14).

14. Verfahren nach Anspruch 12, ferner umfassend Vorsehen eines optischen Umwandlungsmaterials (46) direkt über Abschnitten jedes Leuchtdiodenchips (14).

## Revendications

1. Boîtier d'éléments électroluminescents (10) comprenant :
une embase (12) comprenant une anode (16) et une cathode (18), dans lequel un espace (G) est ménagé entre l'anode (16) et la cathode (18) ;
une pluralité de puces à diodes électroluminescentes (14) disposées par-dessus l'embase (12), dans lequel chacune des puces à diodes électroluminescentes (14) est électriquement connectée à l'anode (1) et à la cathode (18) ; et **caractérisé par** :
un matériau de masque de soudure réfléchissant (26) disposé uniquement dans l'espace (G) pour accroître une quantité de lumière émise par le boîtier d'éléments électroluminescents (10), dans lequel une puce à diode électroluminescente (14) de la pluralité de puces à diodes électroluminescentes (14) est connectée par fil à au moins une partie de l'anode.

2. Boîtier d'éléments électroluminescents (10) selon la revendication 1, dans lequel le boîtier (10) est conçu pour délivrer jusqu'à environ 145 lumens par watt (lm/W) ou plus lorsqu'il fonctionne à une puissance électrique de 1 W et à une température d'intervalle de classe d'environ 25 °C.

3. Boîtier d'éléments électroluminescents (10) selon la revendication 1, dans lequel le boîtier (10) est conçu pour délivrer jusqu'à environ 180 lumens par watt (lm/W) ou plus lorsqu'il fonctionne à une puissance électrique de 1 W et à une température d'intervalle de classe d'environ 25 °C.

4. Boîtier d'éléments électroluminescents (10) selon la revendication 1, dans lequel le boîtier (10) est conçu pour délivrer jusqu'à environ 200 lumens par watt (lm/W) ou plus lorsqu'il fonctionne à une puissance électrique de 1 W et à une température d'intervalle de classe d'environ 25 °C.

5. Boîtier d'éléments électroluminescents (10) selon la revendication 1, dans lequel le matériau de masque de soudure réfléchissant (26) comprend un matériau de masque de soudure blanc (26).

6. Boîtier d'éléments électroluminescents (10) selon la revendication 1, comprenant en outre un matériau de conversion optique (46) disposé par-dessus chaque puce (14) de la pluralité de puces (14).

7. Boîtier d'éléments électroluminescents (10) selon la revendication 6, dans lequel le matériau de conversion optique (46) comprend un luminophore, et dans lequel le luminophore n'est disposé que par-dessus chaque puce (14) de la pluralité de puces (14).

8. Boîtier d'éléments électroluminescents (10) selon la revendication 1, dans lequel le boîtier (10) est conçu pour délivrer une plage de températures de couleurs allant d'environ 2700 à 7000 K lorsqu'il est activé par un courant électrique.

9. Boîtier d'éléments électroluminescents (10) selon la revendication 1, dans lequel des première et seconde puces à diodes électroluminescentes (14) sont espacées d'au moins 0,025 mm environ.

10. Boîtier d'éléments électroluminescents (10) selon la revendication 1, dans lequel l'embase (12) présente une aire supérieure ou égale à environ 49 mm².

11. Boîtier d'éléments électroluminescents (10) selon la revendication 1, dans lequel l'embase (12) possède une conductivité thermique supérieure ou égale à environ 30 watts par mètre kelvin (W/m·K).

12. Procédé de production d'un boîtier d'éléments électroluminescents (10), le procédé comprenant les étapes suivantes :
mettre en place un substrat (12) comprenant une anode (16) et une cathode (18), dans lequel un espace (G) est ménagé entre l'anode (16) et la cathode (18) ;
mettre en place une première puce à diode électroluminescente (14) et une seconde puce à diode électroluminescente (14) par-dessus l'embase (12), dans lequel les première et seconde puces à diodes électroluminescentes (14) sont électriquement connectées à l'anode (16) et à la cathode (18) ;
et **caractérisé par** l'étape suivante :
mettre en place un matériau de masque de soudure réfléchissant (26) uniquement dans l'espace (G) pour accroître une quantité de lumière émise par le boîtier d'éléments électroluminescents (10).

13. Procédé selon la revendication 12, comprenant en outre la mise en place d'une chaîne de puces à diodes électroluminescentes (14) connectées en série, entre les première et seconde puces à diodes électroluminescentes (14).

14. Procédé selon la revendication 12, comprenant en outre la mise en place d'un matériau de conversion optique (46) directement par-dessus des parties de chaque puce à diode électroluminescente (14).
